# EUROPEAN PATENT APPLICATION

(11) **EP 4 718 985 A1**
(43) Date of publication of application: **01.04.2026**
(21) Application number: 25202833.7
(22) Date of filing: 17.09.2025
(51) Int. Cl.: H10D 62/10, H10D 30/01, H10D 30/00, H10D 84/01, H10D 84/03, H10D 84/85, H10D 84/83

(54) **FORKSHEET TRANSISTORS WITH WRAPPED-AROUND GATE DIELECTRIC**

(30) Priority: 27.09.2024 US 202418899748
(71) Applicant: INTEL Corporation, Santa Clara, CA 95054 (US)
(72) Inventor: PRINCE, Matthew J., Portland, 97229 (US); LINDERT, Nick, Portland, 97229 (US); GOMEZ, Harry, Hillsboro, 97124 (US); LUCE, Jeanne L., Hillsboro, 97123 (US); BERGSTROM, Daniel, Lake Oswego, 97035 (US); GULER, Leonard P., Hillsboro, 97124 (US); JAYANTI, Srikant, San Leandro, 94579 (US); JALOVIAR, Steven G., Banks, 97106 (US); TOWNER, David J., Portland, 97225 (US); KIOUSSIS, Dimitri, San Jose, 95118 (US); SEHGAL, Akshey, Newark, 94560 (US); GHOSTINE, Ramy, Portland, 97229 (US); MICHAELOS, Thoe, Portland, 97212 (US); TIWARI, Vishal, Hillsboro, 97123 (US); CHU, Tao, Portland, 97229 (US); ZHU, Baofu, Portland, 97229 (US); KOH, Shao-Ming, Mountain View, 94041 (US); YOGENDRA, Karthik, Hillsboro, 97123 (US); RICH, Suzanne S., Hillsboro, 97124 (US)
(74) Representative: 2SPL Patentanwälte PartG mbB

(57) **Abstract**

Techniques are provided to form semiconductor devices that include forksheet transistors with a self-aligned dielectric spine and nanosheets with a wrapped-around gate dielectric. The dielectric spine may be formed prior to the formation of gate structures. In an example, first and second semiconductor devices have first and second semiconductor regions, respectively, extending in a first direction. The first and second semiconductor regions may include any number of nanosheets. A dielectric spine extends in the first direction centrally aligned between the first and second semiconductor regions. The gate dielectric of the gate structures on either side of the dielectric spine is wrapped around the semiconductor regions, such that the gate dielectric is present between the nanosheets and the dielectric spine along the second direction. The dielectric spine may include a dielectric liner that itself is removed prior to formation of the gate structures, thus provided space for the wrapped-around gate dielectric.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional views of some semiconductor devices that illustrate forksheet transistors having a wrapped-around gate dielectric and a self-aligned dielectric spine, in accordance with some embodiments of the present disclosure.
Figure 1C is a plan view through the semiconductor devices of Figures 1A and 1B, in accordance with some embodiments of the present disclosure.
Figures 2A and 2B are cross-sectional views that illustrate a stage in an example process for forming forksheet transistors having a wrapped-around gate dielectric and a self-aligned dielectric spine, in accordance with some embodiments of the present disclosure.
Figures 3A and 3B are cross-sectional views that illustrate another stage in the example process for forming forksheet transistors having a wrapped-around gate dielectric and a self-aligned dielectric spine, in accordance with some embodiments of the present disclosure.
Figures 4A and 4B are cross-sectional views that illustrate another stage in the example process for forming forksheet transistors having a wrapped-around gate dielectric and a self-aligned dielectric spine, in accordance with some embodiments of the present disclosure.
Figures 5A and 5B are cross-sectional views that illustrate another stage in the example process for forming forksheet transistors having a wrapped-around gate dielectric and a self-aligned dielectric spine, in accordance with some embodiments of the present disclosure.
Figures 6A and 6B are cross-sectional views that illustrate another stage in the example process for forming forksheet transistors having a wrapped-around gate dielectric and a self-aligned dielectric spine, in accordance with some embodiments of the present disclosure.
Figures 7A and 7B are cross-sectional views that illustrate another stage in the example process for forming forksheet transistors having a wrapped-around gate dielectric and a self-aligned dielectric spine, in accordance with some embodiments of the present disclosure.
Figures 8A and 8B are cross-sectional views that illustrate another stage in the example process for forming forksheet transistors having a wrapped-around gate dielectric and a self-aligned dielectric spine, in accordance with some embodiments of the present disclosure.
Figures 9A and 9B are cross-sectional views that illustrate another stage in the example process for forming forksheet transistors having a wrapped-around gate dielectric and a self-aligned dielectric spine, in accordance with some embodiments of the present disclosure.

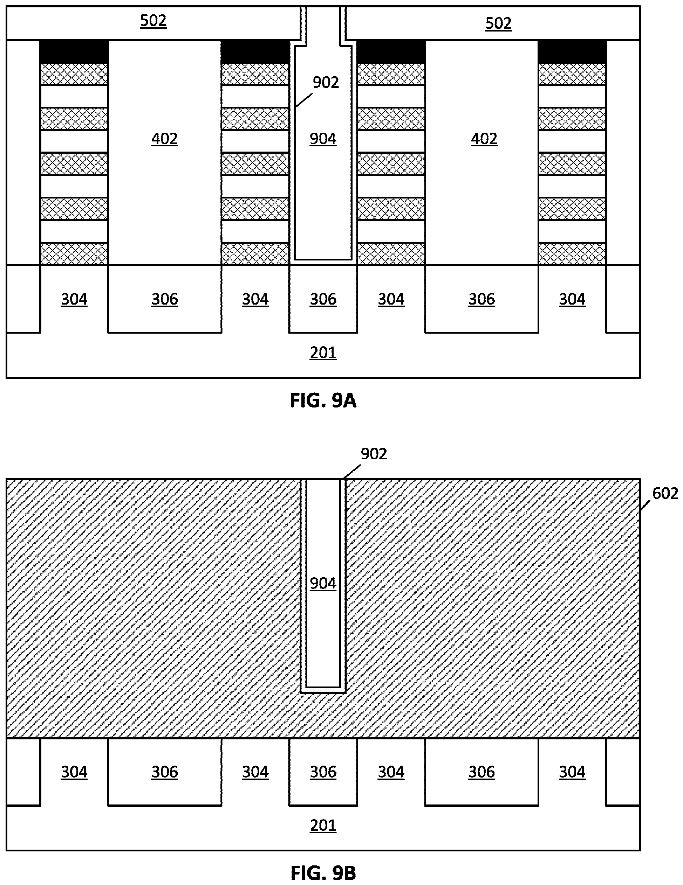

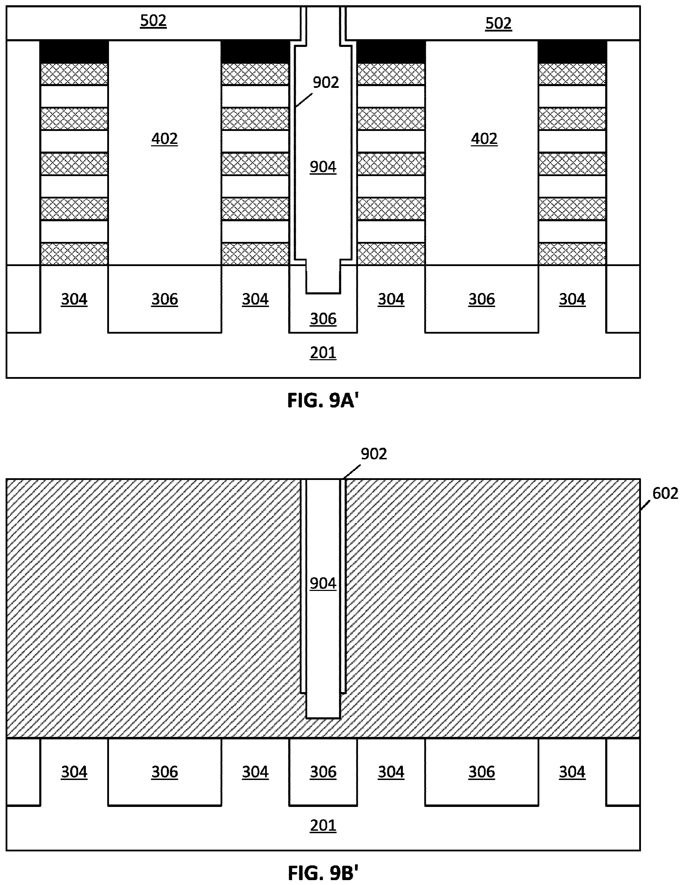

Figures 9A' and 9B' are cross-sectional views that illustrate an alternative stage in the example process for forming forksheet transistors having a wrapped-around gate dielectric and a self-aligned dielectric spine, in accordance with some embodiments of the present disclosure.

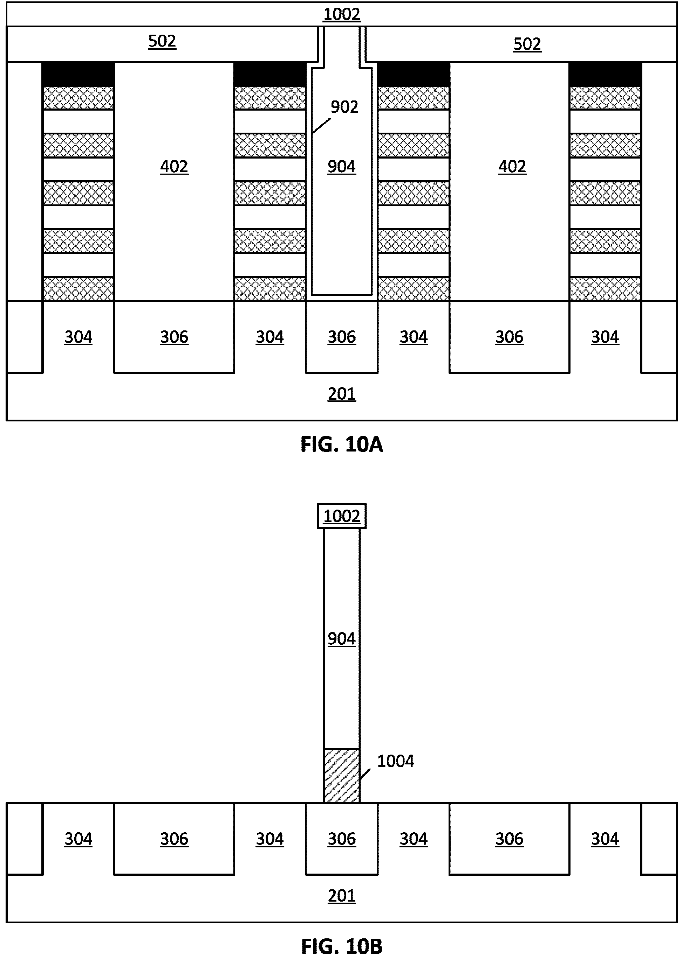

Figures 10A and 10B are cross-sectional views that illustrate another stage in the example process for forming forksheet transistors having a wrapped-around gate dielectric and a self-aligned dielectric spine, in accordance with some embodiments of the present disclosure.

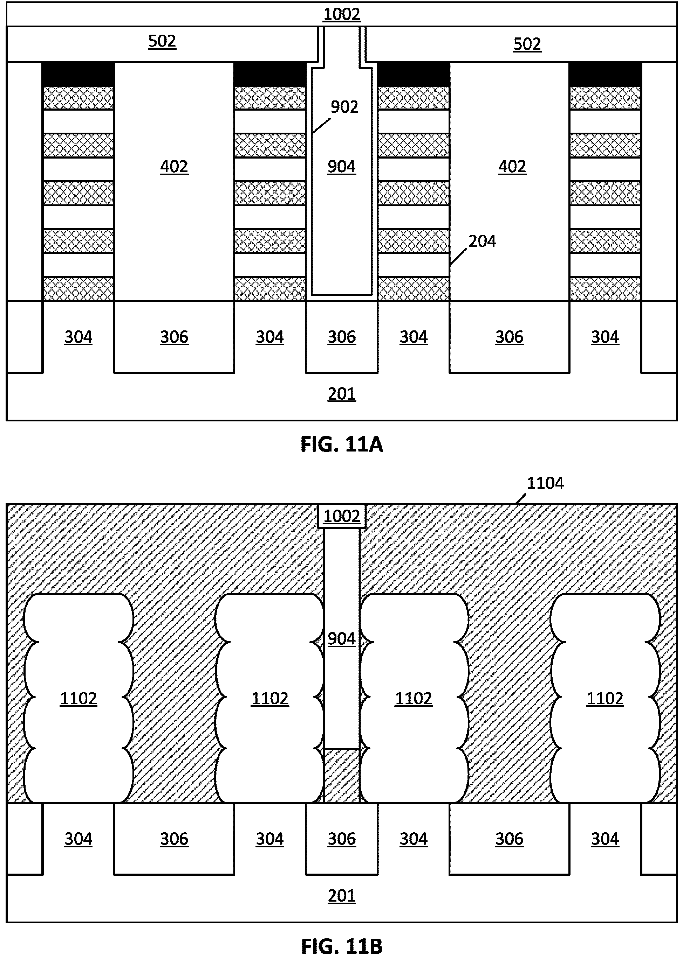

Figures 11A and 11B are cross-sectional views that illustrate another stage in the example process for forming forksheet transistors having a wrapped-around gate dielectric and a self-aligned dielectric spine, in accordance with some embodiments of the present disclosure.

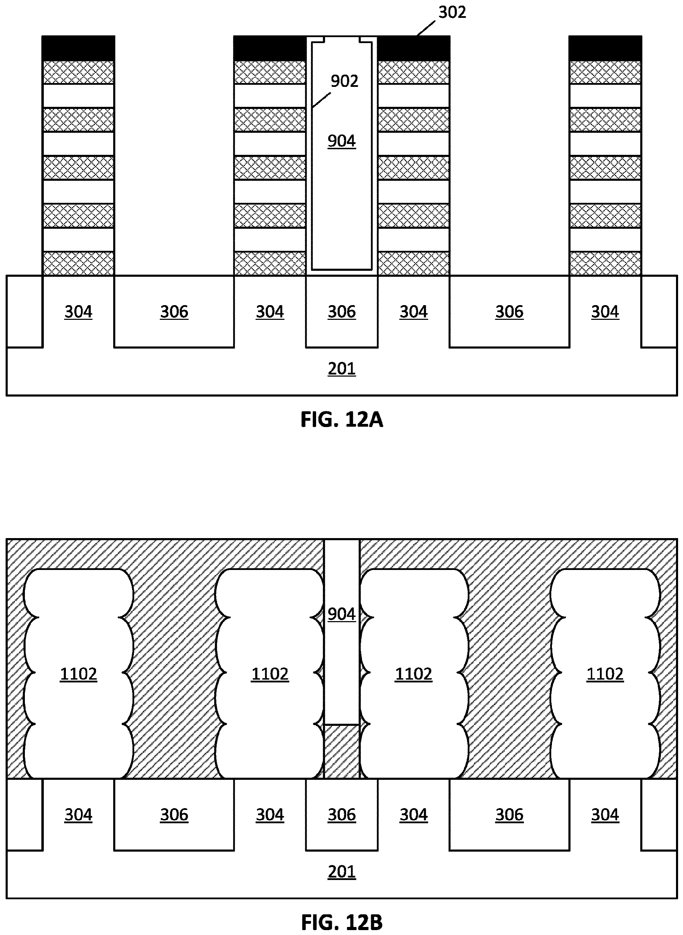

Figures 12A and 12B are cross-sectional views that illustrate another stage in the example process for forming forksheet transistors having a wrapped-around gate dielectric and a self-aligned dielectric spine, in accordance with some embodiments of the present disclosure.

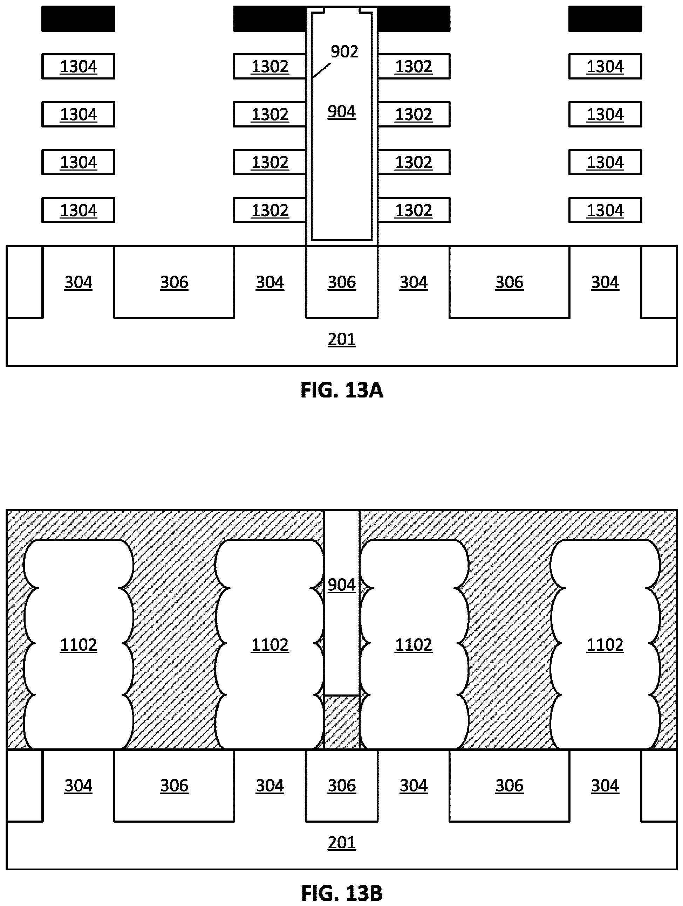

Figures 13A and 13B are cross-sectional views that illustrate another stage in the example process for forming forksheet transistors having a wrapped-around gate dielectric and a self-aligned dielectric spine, in accordance with some embodiments of the present disclosure.

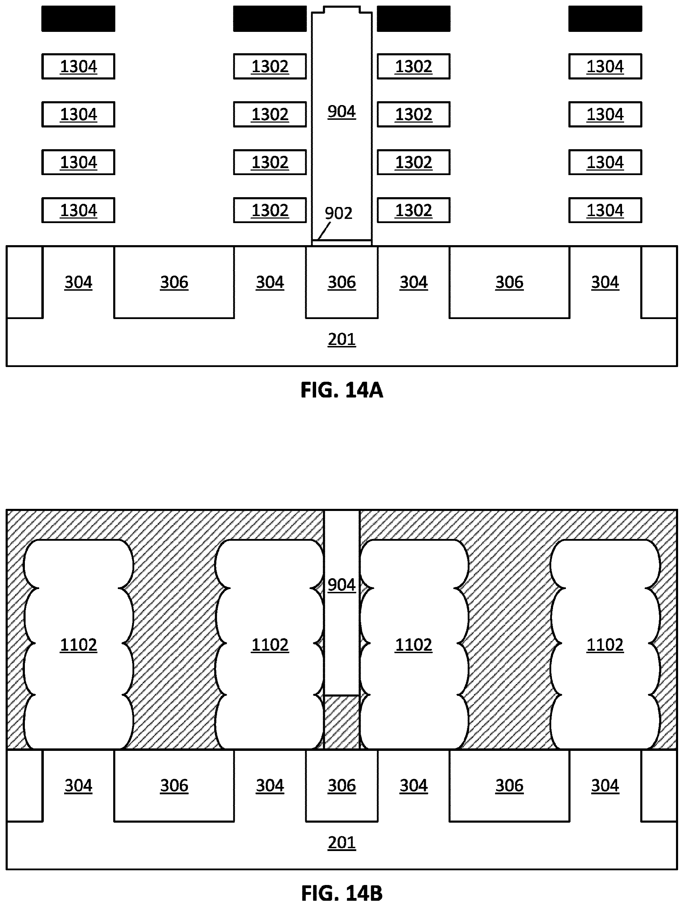

Figures 14A and 14B are cross-sectional views that illustrate another stage in the example process for forming forksheet transistors having a wrapped-around gate dielectric and a self-aligned dielectric spine, in accordance with some embodiments of the present disclosure.

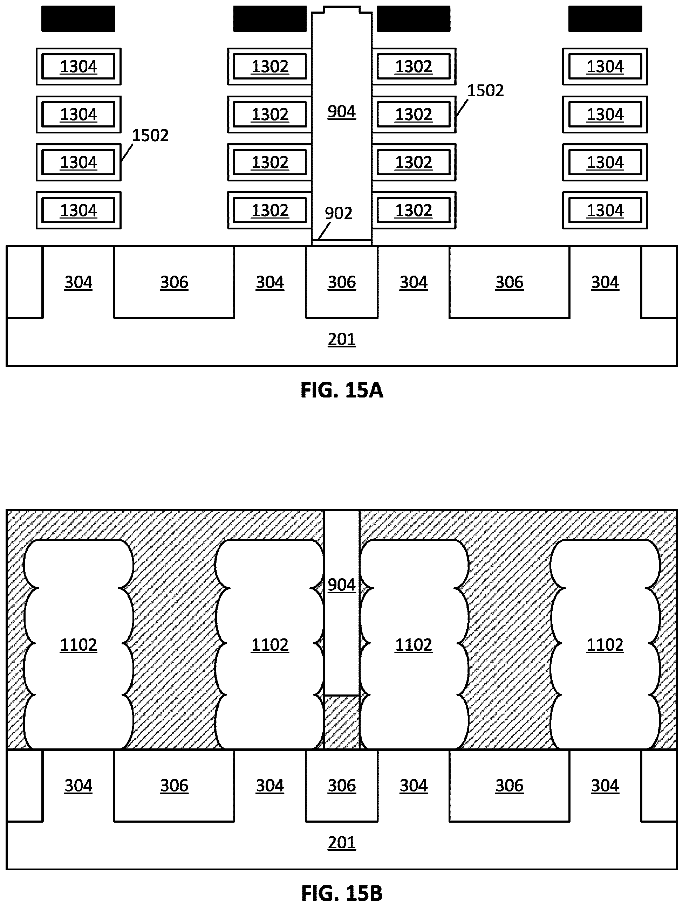

Figures 15A and 15B are cross-sectional views that illustrate another stage in the example process for forming forksheet transistors having a wrapped-around gate dielectric and a self-aligned dielectric spine, in accordance with some embodiments of the present disclosure.

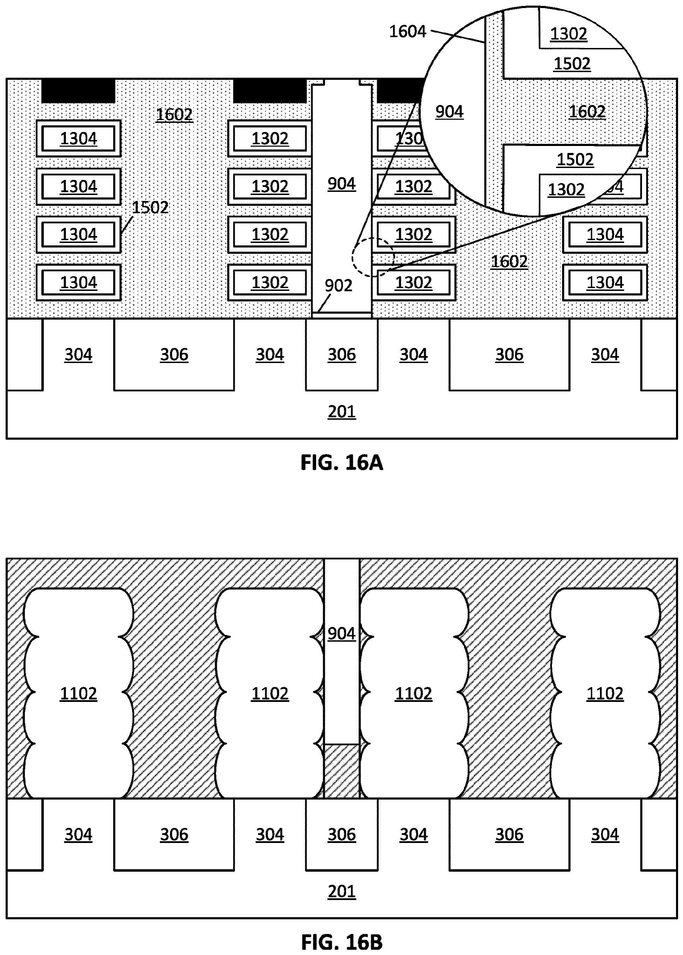

Figures 16A and 16B are cross-sectional views that illustrate another stage in the example process for forming forksheet transistors having a wrapped-around gate dielectric and a self-aligned dielectric spine, in accordance with some embodiments of the present disclosure.

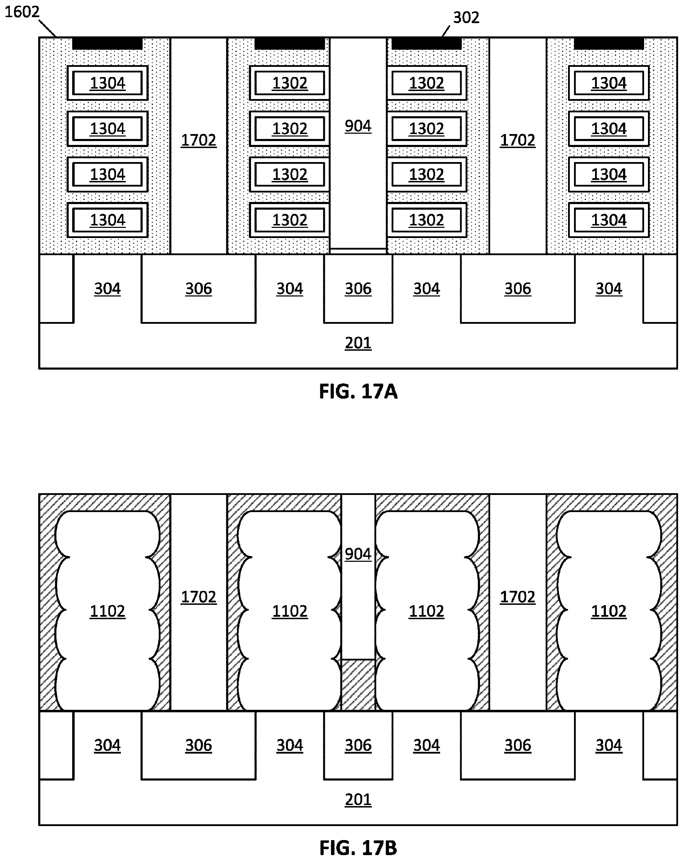

Figures 17A and 17B are cross-sectional views that illustrate another stage in the example process for forming forksheet transistors having a wrapped-around gate dielectric and a self-aligned dielectric spine, in accordance with some embodiments of the present disclosure.

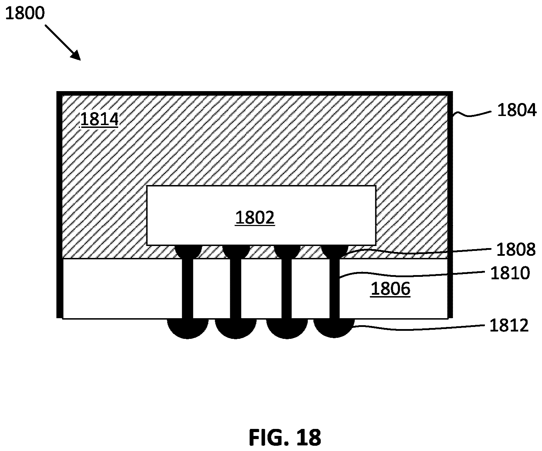

Figure 18 illustrates a cross-sectional view of a chip package containing one or more semiconductor dies as variously described herein, in accordance with some embodiments of the present disclosure.

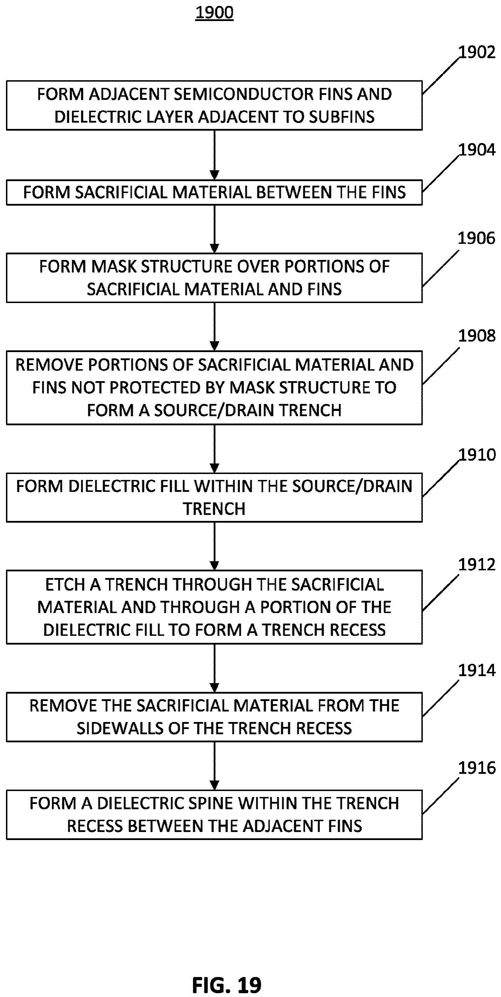

Figure 19 is a flowchart of a fabrication process for forksheet transistors with a self-aligned dielectric spine, in accordance with an embodiment of the present disclosure.

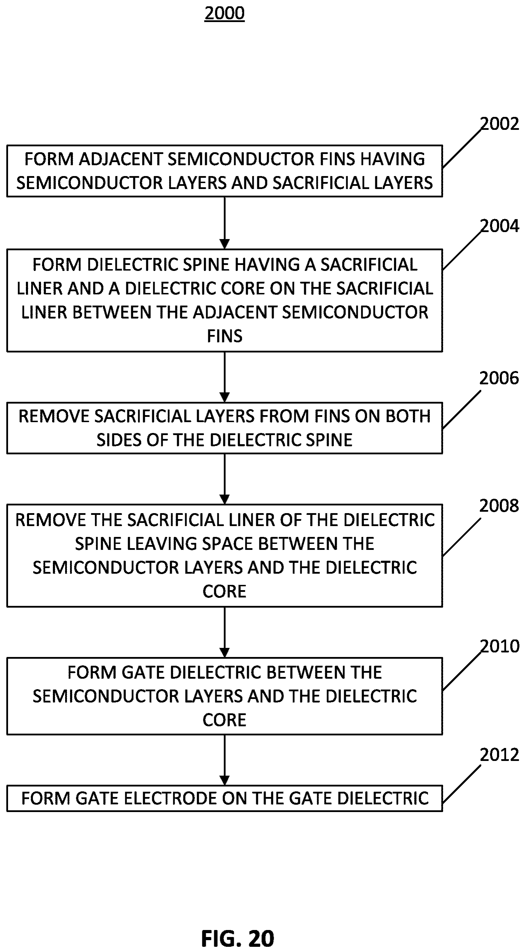

Figure 20 is a flowchart of a fabrication process for forksheet transistors having a wrapped-around gate dielectric, in accordance with an embodiment of the present disclosure.

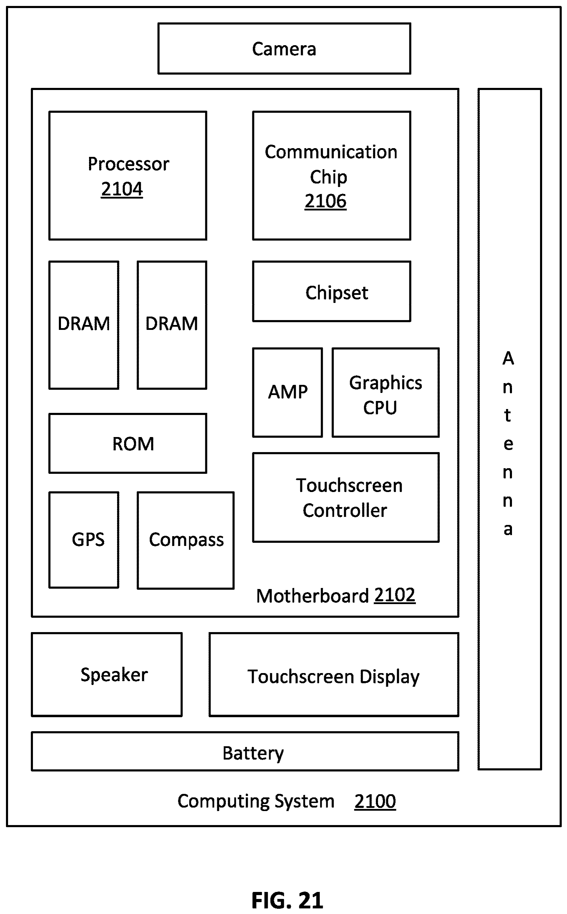

Figure 21 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include forksheet transistors with a self-aligned dielectric spine and nanosheets with a wrapped-around gate dielectric. As used herein, a wrapped-around gate dielectric refers to a gate dielectric that is present around all sides of a semiconductor nanosheet, including between the semiconductor nanosheet and the adjacent dielectric spine. According to some embodiments, the dielectric spine is formed prior to the formation of gate structures. In an example, first and second semiconductor devices have first and second semiconductor regions, respectively, extending in a first direction between corresponding source and drain regions. A first gate structure extends in a second direction over the first semiconductor regions, and a second gate structure extends in the second direction over the second semiconductor regions. The first and second semiconductor regions may include any number of nanosheets. A dielectric spine extends in the first direction between the first and second semiconductor regions. The dielectric spine can be formed before the final gate structures are formed and even before the source and drain regions are formed. In some embodiments, the gate dielectric of the gate structures on either side of the dielectric spine is wrapped around the semiconductor regions, such that the gate dielectric is present between the nanosheets and the dielectric spine along the second direction. In an example, a sacrificial material is formed between the fins and is later removed and replaced with the dielectric spine. The dielectric spine may include a dielectric liner that itself is removed prior to formation of the gate structures, thus allowing the gate dielectric to be formed around all sides of the semiconductor nanosheets adjacent to the dielectric spine. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like gate cuts are used in integrated circuit design to isolate gate structures from one another. Another example is a dielectric spine of a forksheet transistor arrangement. Like the gate cut, the dielectric spine extends across a gate trench and separates gate structures on either side of the dielectric spine. However, the semiconductor regions of semiconductor devices on either side of the dielectric spine abut the sides of the dielectric spine, such that the gate does not extend completely around the semiconductor regions. This structure allows the forksheet transistors to be patterned very close together (e.g., with only the dielectric spine between them). However, due to the closely packed nature of the forksheet transistors, shorting can be a problem if the integrity of the dielectric spine degrades during fabrication. In more detail, the dielectric spine is formed fairly early in the fabrication process (just after fin formation), which requires protecting the dielectric material through several subsequent processing operations. But protecting the dielectric spine is challenging and the subsequent fabrication processes often result in portions of the dielectric spine being etched away. Additionally, the dielectric spine directly abuts the semiconductor regions in the forksheet architecture. While this can offer lower parasitic capacitance, the loss of one side of the gate on the semiconductor channel leads to degraded electrostatic control compared to gate-all-around (GAA) transistors.

Thus, and in accordance with an embodiment of the present disclosure, techniques are provided herein to form a self-aligned dielectric spine of forksheet transistors later in the overall device fabrication process that is slightly offset from the adjacent semiconductor regions, thus allowing for a wrapped-around gate dielectric on the semiconductor regions. According to some embodiments, two semiconductor fins having layers of alternating semiconductor material are formed that run parallel to one another along a first direction and are relatively close to one another (e.g., within 20 nm of each other) along an orthogonal second direction. Each fin of semiconductor material will ultimately form a single transistor on each side of a forksheet arrangement. According to some embodiments, a sacrificial material is formed between the fins shortly after the fin formation. The sacrificial material may be patterned in a similar fashion to a sacrificial (or dummy) gate to define gate trenches having the sacrificial material and adjacent source/drain trenches where the sacrificial material is removed. Portions of the fins within the source/drain trenches are removed and the source/drain trenches may be filled with a placeholder dielectric material. According to some embodiments, a trench is etched that extends lengthwise along the first direction through the sacrificial material between the fins. The trench also extends through the placeholder dielectric material along the first direction. Any remaining portions of the sacrificial material on the sidewalls of the trench may be removed, followed by the formation of a dielectric spine within the trench.

According to some embodiments, the dielectric spine includes a sacrificial liner and a dielectric core on the sacrificial liner. The sacrificial liner may be any material that can be easily removed with respect to the dielectric core, such as silicon dioxide or aluminum nitride with a core of silicon nitride, silicon oxynitride, or silicon carbonitride. Following the release of nanosheets on either side of the dielectric spine, the dielectric liner may be removed thus creating space along the second direction between edges of the nanosheets and the dielectric core. A gate dielectric may then be formed at least on all exposed semiconductor surfaces within the gate trench, which includes the surfaces of the nanosheets that face the dielectric core. In this way, the gate dielectric wraps around the nanosheets. In some examples, portions of the gate electrode may also be present between the gate dielectric on the nanosheets and the dielectric core of the dielectric spine.

According to an embodiment, an integrated circuit includes a first semiconductor device and a second semiconductor device. The first semiconductor device has a first semiconductor material extending in a first direction from a first source or drain region, and a first gate structure extending in a second direction over the first semiconductor material. The second semiconductor device has a second semiconductor material extending in the first direction from a second source or drain region, and a second gate structure extending in the second direction over the second semiconductor material. The second source or drain region is aligned with the first source or drain region along the second direction The integrated circuit further includes a dielectric spine extending in the first direction between the first semiconductor material and the second semiconductor material and between the first source or drain region and the second source or drain region. The dielectric spine has a first width along the second direction between the first semiconductor material and the second semiconductor material and a second width between the first source or drain region and the second source or drain region that is at least 2 nm smaller than the first width.

According to an embodiment, an integrated circuit includes a first semiconductor device having a first semiconductor material extending in a first direction from a first source or drain region and a first gate structure extending in a second direction over the first semiconductor material, a second semiconductor device having a second semiconductor material extending in the first direction from a second source or drain region and a second gate structure extending in the second direction over the second semiconductor material, and a dielectric spine extending in the first direction between the first semiconductor material and the second semiconductor material and between the first source or drain region and the second source or drain region. The second source or drain region is aligned with the first source or drain region along the second direction. The dielectric spine has a first height along a third direction between the first semiconductor material and the second semiconductor material and a second height along the third direction between the first source or drain region and the second source or drain region that is at least 10 nm smaller than the first height.

According to an embodiment, a method of forming an integrated circuit includes forming a first fin comprising first semiconductor material and a first dielectric cap over the first semiconductor material, and a second fin comprising second semiconductor material and a second dielectric cap over the second semiconductor material, wherein the first fin and the second fin are adjacent and extend parallel to one another along a first direction; forming a sacrificial material between the first fin and the second fin and extending along at least an entire height of the first fin and the second fin; forming a mask structure over portions of the sacrificial material and over portions of the first and second fins; removing portions of the sacrificial material and the first and second fins not protected by the mask structure to form a source/drain trench; forming a dielectric fill within the source/drain trench; etching a trench extending in the first direction through at least an entire height of the sacrificial material between the first fin and the second fin and through at least a portion of the dielectric fill to form a trench recess; removing the sacrificial material on sidewalls of the trench recess; and forming one or more dielectric materials within the trench recess to form a dielectric spine between the first fin and the second fin.

According to an embodiment, another method of forming an integrated circuit includes forming a first fin comprising first semiconductor material layers and first sacrificial material layers, and a second fin comprising second semiconductor material layers and second sacrificial material layers, wherein the first fin and the second fin are adjacent and extend parallel to one another along a first direction; forming a dielectric spine directly between and contacting the first fin and the second fin, the dielectric spine comprising a dielectric liner and a dielectric fill on the dielectric liner; removing the first sacrificial layers and the second sacrificial layers to leave first and second nanosheets, respectively, on either side of the dielectric spine; removing the dielectric liner of the dielectric spine; and forming a first gate dielectric around the first semiconductor nanosheets and a second gate dielectric around the second semiconductor nanosheets, such that the first gate dielectric is between the first semiconductor nanosheets and the dielectric fill of the dielectric spine along a second direction substantially orthogonal to the first direction, and the second gate dielectric is between the second semiconductor nanosheets and the dielectric fill of the dielectric spine along the second direction.

The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate that the width of the dielectric spine (along the second direction) between the nanosheets is greater than the width of the dielectric spine between the source or drain regions. In some embodiments, such tools may indicate a high-k material (e.g., the gate dielectric) conformally around the nanosheets such that the high-k material is also present directly between the semiconductor nanosheets and the dielectric spine. In some such cases, the dielectric spine may be in direct contact with the gate dielectric. In some examples, the dielectric spine has a first height between the nanosheets and a second height between the source or drain regions that is less than the first height. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

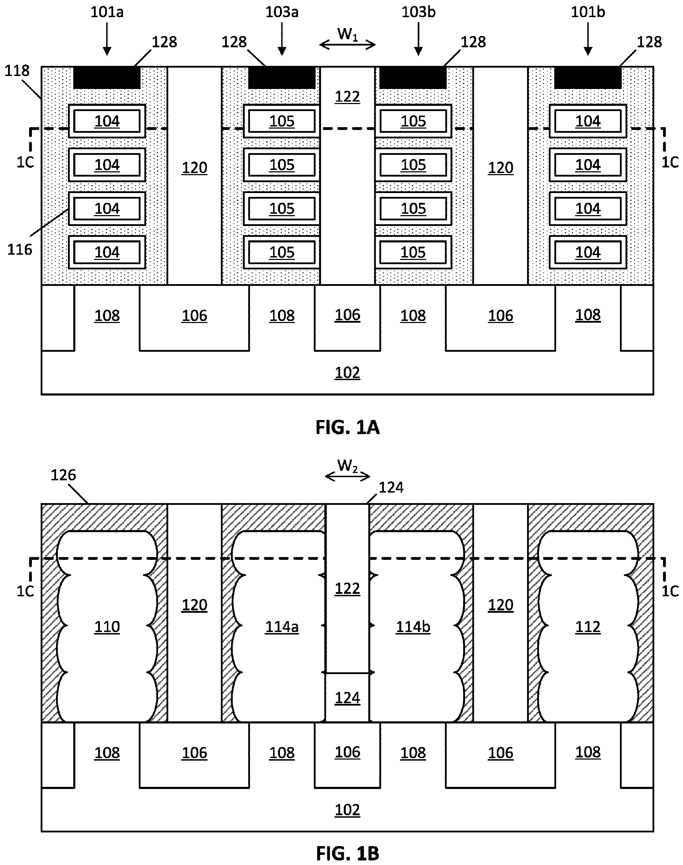

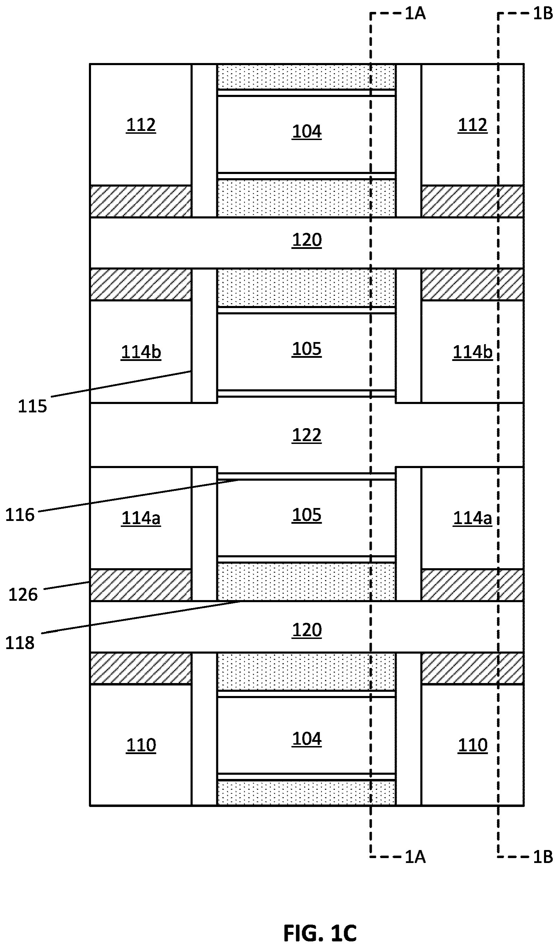

Figure 1A is a cross-sectional view taken across the gate trench of four example semiconductor devices, according to an embodiment of the present disclosure. Figure 1B is another cross-sectional view taken across the source/drain trench adjacent to the gate trench either into or out of the page of Figure 1A. Figure 1C is a top-down cross-section view of the adjacent semiconductor devices taken across the dashed line 1C-1C depicted in both Figure 1A and Figure 1B. Figure 1A illustrates the cross-section taken across the dashed line 1A-1A depicted in Figure 1C, and Figure 1B illustrates the cross-section taken across the dashed line 1B-1B depicted in Figure 1C.

According to some embodiments, semiconductor devices 101a and 101b may be gate-all-around (GAA) transistors, and semiconductor devices 103a and 103b are part of a forksheet structure or arrangement having a dielectric spine 122. Other transistor topologies and types (e.g., finFETs, planar transistors) can also be used in conjunction with the forksheet techniques and structures provided herein. According to some embodiments, a given semiconductor device can be formed as either a GAA transistor or as part of a forksheet arrangement based on its distance from adjacent semiconductor devices. Those that are formed relatively close together (e.g., semiconductor devices 103a and 103b) may form a forksheet arrangement while those formed further apart from adjacent devices (e.g., semiconductor devices 101a and 101b) may form GAA transistors or finFETs (e.g., tri-gate or double-gate). Further details regarding the formation of semiconductor devices 101a, 101b, 103a, and 103b are provided herein. Semiconductor devices 101a, 101b, 103a, and 103b represent a portion of an integrated circuit that may contain any number of similar semiconductor devices.

As can be seen, the semiconductor devices are formed on a substrate 102. Any number of semiconductor devices can be formed on substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and/or power routing.

Each of semiconductor devices 101a and 101b includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. In a similar fashion, each of semiconductor devices 103a and 103b includes one or more nanosheets 105 that extend parallel to one another along the first direction between corresponding source and drain regions. In general, the term nanoribbons refer to semiconductor regions used in a GAA structure that have a gate wrapped around all sides of the semiconductor regions within the gate trench, and the term nanosheets refer to semiconductor regions used in a forksheet structure that are closely adjacent to a dielectric spine (e.g., the gate electrode is not present between the nanosheets and the dielectric spine). The semiconductor material of nanoribbons 104 and nanosheets 105 may be formed from substrate 102. In some embodiments, semiconductor devices 101a, 101b, 103a, and 103b may each include fins with alternating layers of material (e.g., alternating layers of silicon and SiGe) that facilitates forming of the illustrated nanoribbons 104 and nanosheets 105 during a gate forming process where one type of the alternating layers is selectively etched away so as to liberate the other type of alternating layers within the channel region. The alternating layers can be blanket deposited and then etched into fins or deposited into fin-shaped trenches, according to some examples. In the examples shown, nanoribbons 104 and nanosheets 105 appear to have similar geometry. In other examples, nanoribbons 104 and nanosheets 105 may have different geometries.

As can further be seen, adjacent semiconductor devices are separated by a dielectric fill 106 that may include silicon dioxide. Dielectric fill 106 provides shallow trench isolation (STI) between adjacent subfin regions 108 of any adjacent semiconductor devices. Dielectric fill 106 can be any suitable dielectric material, such as silicon dioxide, aluminum oxide, or silicon oxycarbonitride.

According to some embodiments, subfin regions 108 comprise the same semiconductor material as substrate 102 and are adjacent to dielectric fill 106. According to some embodiments, nanoribbons 104 (or other semiconductor bodies) extend between a source and a drain region in the first direction to provide an active region for a GAA transistor (e.g., the semiconductor region beneath the gate), and nanosheets 105 extend between a source and a drain region in the first direction to provide an active region for a forksheet transistor. The source and drain regions are not shown in the cross-section of Figure 1A, but are seen in the cross-section view of Figure 1B and the plan view of Figure 1C where nanoribbons 104 of semiconductor device 101a extend between source or drain regions 110, nanoribbons 104 of semiconductor device 101b extend between source or drain regions 112, nanosheets 105 of semiconductor device 103a extend between source or drain regions 114a, and nanosheets 105 of semiconductor device 103b extend between source or drain regions 114b. Figure 1C also illustrates gate spacer structures 115 that extend around the ends of nanoribbons 104 and nanosheets 105 and along sidewalls of the gate structures so as to isolate the gate structures from the neighboring source or drain regions. Spacer structures 115 may include a dielectric material, such as silicon nitride.

According to some embodiments, the source and drain regions 110, 112, 114a, 114b are epitaxial regions that are provided using an etch-and-replace process. In other embodiments one or both of the source and drain regions could be, for example, implantation-doped native portions of the semiconductor fins or substrate. Any semiconductor materials suitable for source and drain regions can be used (e.g., group IV and group III-V semiconductor materials). The source and drain regions may include multiple layers such as liners and capping layers to improve contact resistance. In any such cases, the composition and doping of the source and drain regions may be the same or different, depending on the type (e.g., n-type or p-type) of the transistors. For example, one transistor may be a p-type MOS (PMOS) transistor, and another transistor may be an n-type MOS (NMOS) transistor. Any number of source and drain configurations and materials can be used.

According to some embodiments, gate structures extend over the nanoribbons 104 and nanosheets 105 of the different semiconductor devices. For example, a first gate structure extends over nanoribbons 104 of semiconductor device 101a along a second direction across the page, a second gate structure extends over nanoribbons 104 of semiconductor device 101b along the second direction, a third gate structure extends over nanosheets 105 of semiconductor device 103a along the second direction, and a fourth gate structure extends over nanosheets 105 of semiconductor device 103b along the second direction. The second direction may be orthogonal to the first direction. Each gate structure includes a respective gate dielectric 116 and a gate electrode (or gate layer) 118. Gate dielectric 116 represents any number of dielectric layers present between nanoribbons 104/nanosheets 105 and gate electrode 118. Portions of gate dielectric 116 may also be present on the surfaces of other structures within the gate trench, such as on a top surface of subfin region 108. Gate dielectric 116 may include any suitable gate dielectric material(s). In some embodiments, gate dielectric 116 includes a layer of native oxide material (e.g., silicon dioxide) on the semiconductor nanoribbons/nanosheets 104, 105 making up the channel region of the devices, and a layer of high-k dielectric material (e.g., hafnium oxide) on the native oxide.

Gate electrode 118 may represent any number of conductive layers, such as any metal, metal alloy, or doped polysilicon layers. In some embodiments, gate electrode 118 includes one or more workfunction metals around nanoribbons 104 and nanosheets 105. In some embodiments, at least one of the semiconductor devices is a p-channel device that includes a workfunction metal having titanium around its nanoribbons 104 or nanosheets 105 and another semiconductor device is an n-channel device that includes a workfunction metal having tungsten around its nanoribbons 104 or nanosheets 105. Gate electrode 118 may also include a fill metal or other conductive material (e.g., tungsten, ruthenium, molybdenum, copper, aluminum) around the workfunction metals to provide the whole gate electrode structure.

According to some embodiments, adjacent gate structures may be separated along the second direction (e.g., across the page, left to right) by a gate cut 120, which acts like a dielectric barrier or wall between gate structures. Gate cut 120 extends vertically (e.g., in a third direction) through at least an entire thickness of the adjacent gate structure. In some embodiments, gate cut 120 also extends through an entire thickness of dielectric fill 106. According to some embodiments, gate cut 120 is formed from any number of dielectric materials. In some examples, gate cut 120 includes silicon nitride and may also include a core of silicon dioxide or silicon oxynitride. Gate cut 120 may have a top width along the second direction, for instance, between about 15 nm and about 30 nm.

According to some embodiments, adjacent semiconductor devices 103a and 103b are part of a forksheet arrangement with a dielectric spine 122 between them which similarly separates the adjacent gate structures around nanosheets 105 of each of semiconductor devices 103a and 103b. As shown, dielectric spine 122 extends vertically in the third direction through at least an entire thickness of the adjacent gate structures. Unlike gate cut 120, dielectric spine 122 is arranged much closer to nanosheets 105 along the second direction. In some embodiments, at least a portion of gate dielectric 116 wraps around all sides of nanosheets 105 such that the at least a portion of gate dielectric 116 is arranged directly between dielectric spine 122 and nanosheets 105 along the second direction. Accordingly, gate dielectric 116 may directly contact both dielectric spine 122 and nanosheets 105. Some portions of gate dielectric 116 may also form along the sidewalls of dielectric spine 122 within the gate trench.

As noted above, dielectric spine 122 extends in the first direction between adjacent nanosheets 105 and also between adjacent source or drain regions 114a and 114b as seen in Figure 1C. In some examples, gate cut 120 and/or dielectric spine 122 extends across more than one gate trench in the first direction (e.g., cutting through more than one gate structure running parallel along the second direction). Due to the procedure used, different sections of dielectric spine 122 may have a different geometry depending on whether they are in the gate trench (as seen in Figure 1A) or in the source/drain trench (as seen in Figure 1B). For example, dielectric spine 122 may have a first width w₁ between nanosheets 105 (or anywhere within the gate trench) and a second width w₂ between source or drain regions 114a/114b (or anywhere within the source/drain trench) that is less than the first width w₁. In some examples, the second width w₂ is between about 2 nm and about 5 nm smaller than the first width w₁. In some examples, the second width w₂ is up to 10 nm smaller than the first width w₁. The first width w₁ may be between about 15 nm and about 25 nm. Due to natural tapering of the structures as they extend deeper towards substrate 102, the width comparison between different sections of dielectric spine 122 should be taken along the same plane. In another example, dielectric spine 122 may have a first height within the gate trench between nanosheets 105 and a second height within the source/drain trench between source or drain regions 114a/114b that is less than the first height. For example, the second height may be between about 5 nm and about 15 nm smaller than the first height, such as around 10 nm smaller than the first height.

A dielectric plug 124 may be present beneath the section of dielectric spine 122 within the source/drain trench. Accordingly, dielectric plug 124 may also be between source or drain regions 114a/114b along the second direction. In some embodiments, dielectric plug 124 has a different dielectric material compared to dielectric spine 122. Dielectric plug 124 may include silicon dioxide, or any other suitable dielectric material. In some embodiments, the total height of dielectric plug 124 and the section of dielectric spine 122 within the source/drain trench is substantially the same as the total height of the section of dielectric spine 122 within the gate trench.

According to some embodiments, a dielectric fill 126 may be present within the source/drain trench around and/or over the source or drain regions. Dielectric fill 126 may be used to fill any remaining volume within the source/drain trench following the formation of the source or drain regions. Dielectric fill 126 may be any suitable dielectric material, such as silicon dioxide. In some examples, portions of dielectric fill 126 above any of the source or drain regions is removed and replaced with a conductive contact to make electrical connection with the underlying source or drain region. According to an embodiment, dielectric fill 126 is substantially the same dielectric material as dielectric plug 124.

According to some embodiments, cap structures 128 are present above each set of nanoribbons 104 and nanosheets 105. Cap structures 128 may be any suitable dielectric material, such as silicon nitride, and may be used to pattern the locations of the underlying fins that ultimately become nanoribbons 104 and nanosheets 105. In some embodiments, cap structures 128 are removed during the fabrication process through polishing (e.g., after the gate formation) or through etching (e.g., after patterning the location of the fins).

### Fabrication Methodology

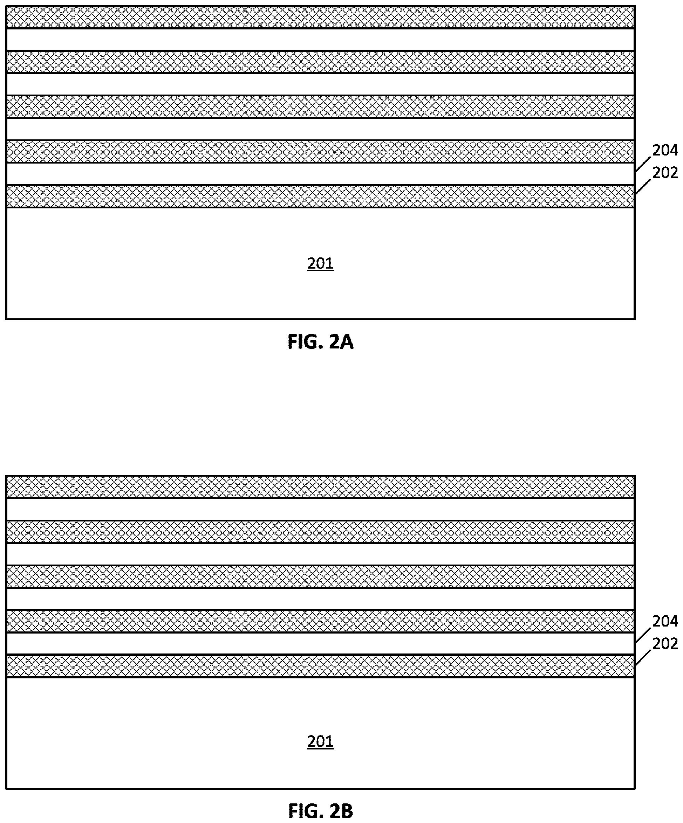

Figures 2A-17A and 2B-17B are cross-sectional views that collectively illustrate an example process for forming an integrated circuit that includes one or more forksheet transistors with a wrapped-around gate dielectric on the nanosheets and a self-aligned dielectric spine, in accordance with an embodiment of the present disclosure. Figures 2A-17A represent cross-sectional views taken across a gate trench of the integrated circuit, while figures 2B-17B represent cross-sectional views taken across the source/drain trench adjacent to the gate trench along the same direction. Each figure shows an example structure that results from the process flow up to that point in time, so the depicted structure evolves as the process flow continues, culminating in the structure shown in Figures 17A and 17B, which is similar to the structure shown in Figures 1A and 1B, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow. Although the fabrication of one dielectric spine is illustrated in the aforementioned figures, it should be understood that any number of similar dielectric spines can be fabricated across the integrated circuit using the same processes discussed herein.

Figures 2A and 2B illustrate parallel cross-sectional views taken through a stack of alternating semiconductor layers on semiconductor substrate 201. Figure 2A is taken across a portion of the stack that will eventually become a gate trench while Figure 2B is taken across a portion of the stack that will eventually become a source/drain trench adjacent and parallel to the gate trench. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. Substrate 201 may be substantially similar to substrate 102 discussed above.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm), and the thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

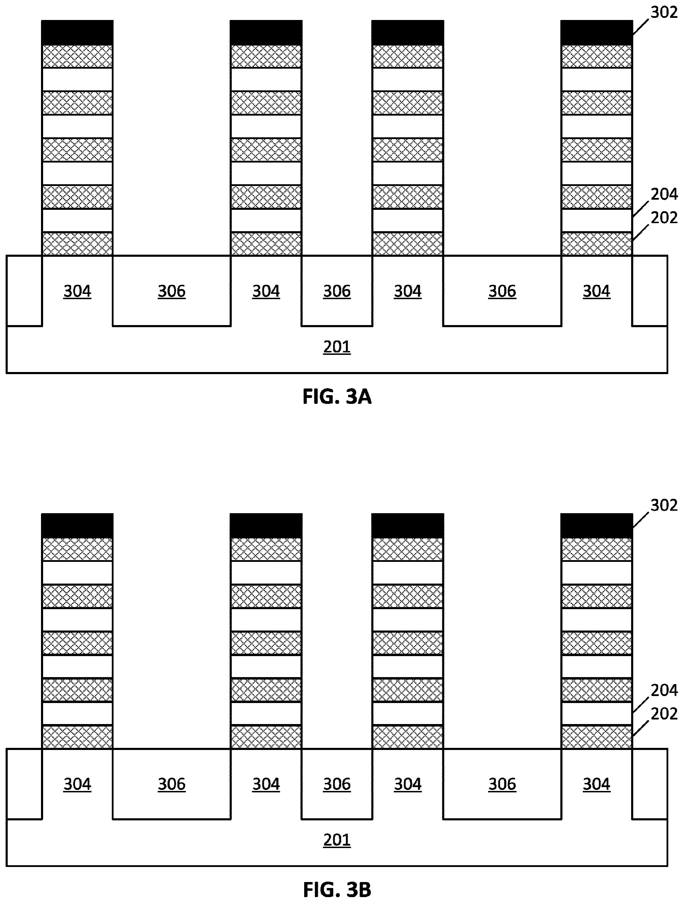

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 304. The etched portions of substrate 201 may be filled with a dielectric fill 306 that acts as shallow trench isolation (STI) between adjacent fins. Dielectric fill 306 may be any suitable dielectric material such as silicon dioxide, and may be recessed to a desired depth as shown (in this example case, down to around the upper surface of subfin regions 304), so as to define the active portion of the fins that will be covered by a gate structure. In some embodiments, dielectric fill 306 is recessed below the top surface of subfin regions 304.

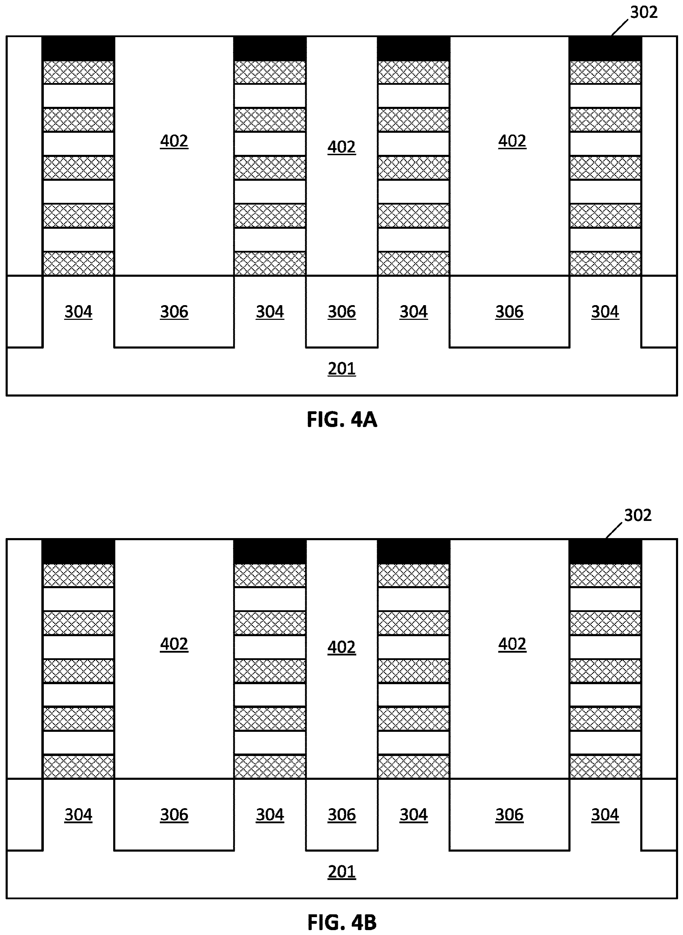

Figures 4A and 4B depict the cross-section views of the structure shown in Figures 3A and 3B, respectively, following the formation of a sacrificial material 402, according to some embodiments. Sacrificial material 402 extends between the fins along a second direction (e.g., across the page). According to some embodiments, sacrificial material 402 is deposited and then polished using, for example, chemical mechanical polishing (CMP) such that a top surface of sacrificial material 402 is substantially coplanar with a top surface of cap layer 302. Sacrificial material 402 may be any suitable material that can be selectively removed without damaging the semiconductor material of the fins. In some examples, sacrificial material 402 includes polysilicon. In some cases, sacrificial material 402 may also include a dielectric liner, such as an oxide of the fin material, which covers the exposed surfaces of the fins.

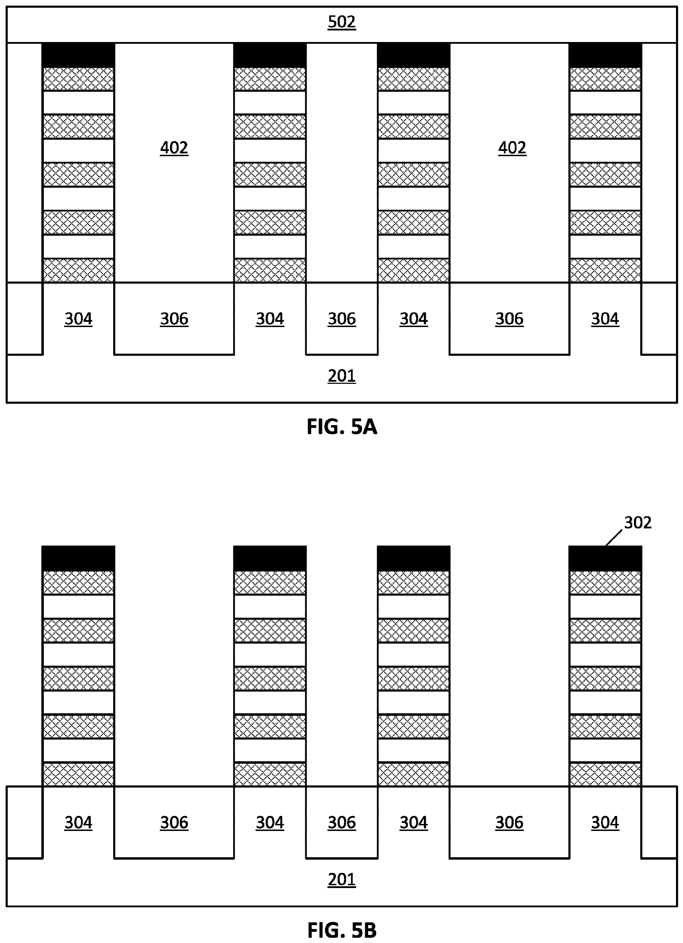

Figures 5A and 5B depict the cross-section views of the structure shown in Figures 4A and 4B, respectively, following the formation of gate mask 502 and subsequent removal of sacrificial material 402 in areas not protected by gate mask 502, according to some embodiments. Gate mask 502 may be any suitable dielectric or hard mask material, such as silicon nitride or a carbon hard mask (CHM). According to some embodiments, gate mask 502 is patterned into parallel strips that extend lengthwise along the second direction over regions that will become the gate trenches (as illustrated in Figure 5A). Any suitable etching process maybe used to remove the exposed portions of sacrificial material 402 from the source/drain trenches (as illustrated in Figure 5B).

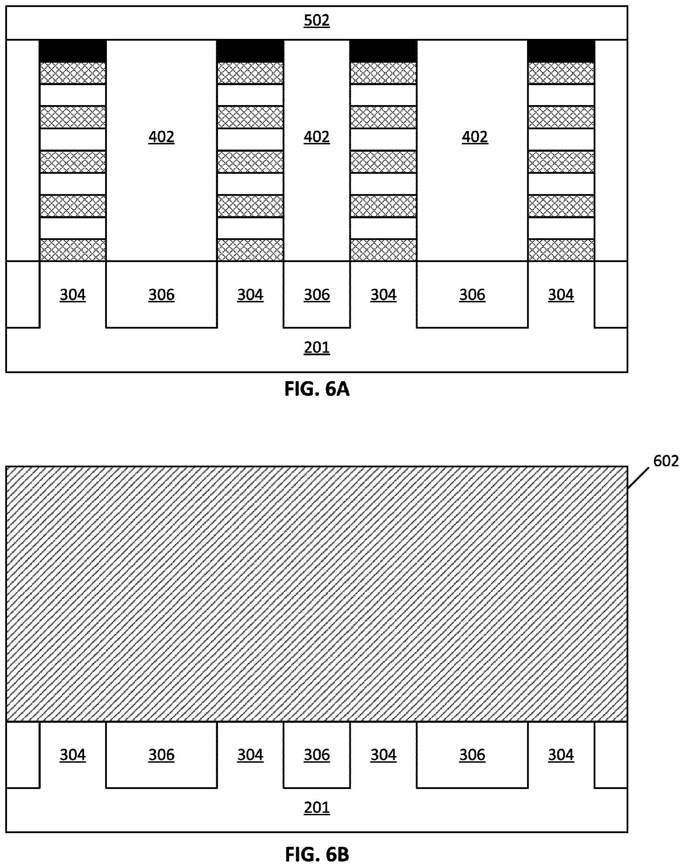

Figures 6A and 6B depict the cross-section views of the structure shown in Figures 5A and 5B, respectively, following the removal of the fin portions from within the source/drain trenches and subsequent formation of a dielectric fill 602 within the source/drain trench, according to some embodiments. Spacer structures may be formed on the sidewalls of sacrificial material 402 (not seen in these cross-sections), and the remaining exposed fin portions within the source/drain trenches may be removed using any suitable etching process or processes. In some examples, the etching process(es) used to remove the fins also removes portions of subfins 304, such that the top surface of subfins 304 is recessed below the top surface of dielectric fill 306.

Following the removal of the fins from the source/drain trench, the source/drain trench may be filled with dielectric fill 602 as seen in Figure 6B. According to some embodiments, dielectric fill 602 occupies the entire volume of the source/drain trench with a top surface that is polished to be substantially coplanar with a top surface of gate mask 502 (or the top surface of the spacer structures on the sidewalls of sacrificial material 402). Dielectric fill 602 may be any suitable dielectric material, such as silicon dioxide. In some examples, dielectric fill 602 is a different dielectric material compared to the spacer structures (e.g., with a high degree of etch selectivity).

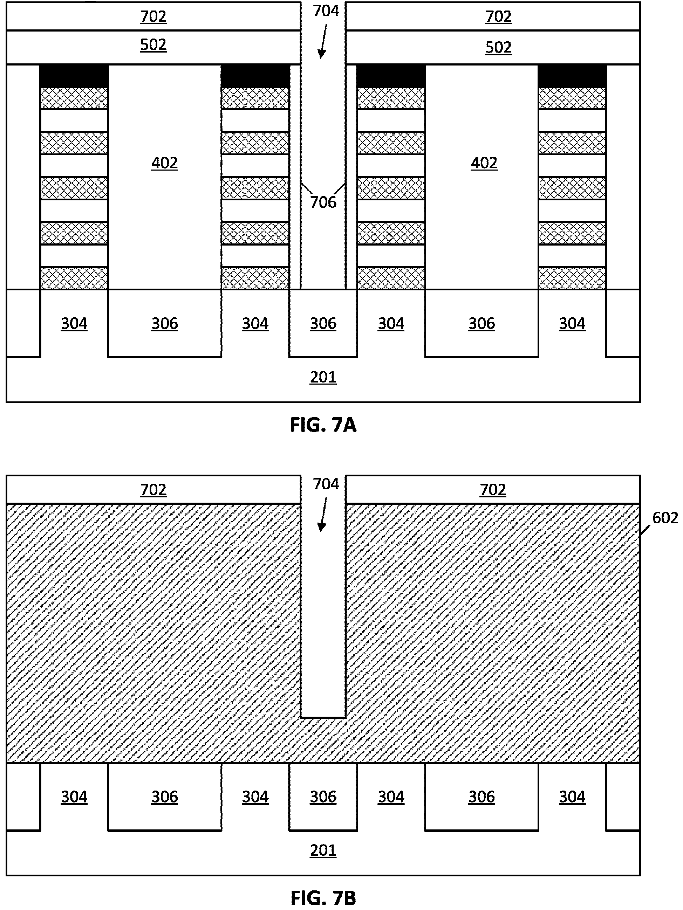

Figures 7A and 7B depict the cross-section views of the structure shown in Figures 6A and 6B, respectively, following the formation of a mask structure 702 over gate mask 502 and over dielectric fill 602, according to some embodiments. Mask structure 702 may represent any number of dielectric or hard mask layers. According to some embodiments, mask structure 702 is patterned with an opening that extends along a first direction and is arranged between two adjacent fins, such as the middle two fins in Figure 7A.

The opening through mask structure 702 is transferred via the same or another etching process through gate mask 502. At this point, the openings through both mask structure 702 and gate mask 502 expose alternating portions of sacrificial material 402 within the gate trenches and dielectric fill 602 within the source/drain trenches. The alignment of the openings through mask structure 702 and gate mask 502 is not critical along the second direction so long as at least some portion of the sacrificial material 402 is exposed between the adjacent fins. According to some embodiments, an RIE process is performed to form a trench recess 704 through both the exposed portions of sacrificial material 402 and through the exposed portions of dielectric fill 602. According to some embodiments, the etching continues until trench recess 704 extends through the entire height of sacrificial material 402, thus exposing at least a portion of dielectric fill 306. In some examples, trench recess 704 extends into at least a portion of dielectric fill 306, or deeper into a portion of substrate 201.

According to some embodiments, the same process used to etch through sacrificial material 402 also etches through dielectric fill 602. However, since the materials are different, the etch rates though them will be different. For example, the etch may proceed faster through sacrificial material 402 as compared to dielectric fill 602. As a result, trench recess 704 may have a first section in the gate trench (Figure 7A) that is deeper than a second section in the source/drain trench (Figure 7B). In some embodiments, the depth of trench recess 704 within the source/drain trench (e.g., through dielectric fill 602) is at least 10 nm smaller than the depth of trench recess 704 within the gate trench (e.g., between the fins).

According to some embodiments, the width of trench recess 704 across the second direction is less than the distance between the adjacent fins across the second direction, as observed in Figure 7A. As a result, portions 706 of the sacrificial material may remain on the sides of the adjacent fins. Portions 706 may remain on both sides of trench recess 704 or on only one side of trench recess 704 depending on the alignment of the openings through mask structure 702 and gate mask 502.

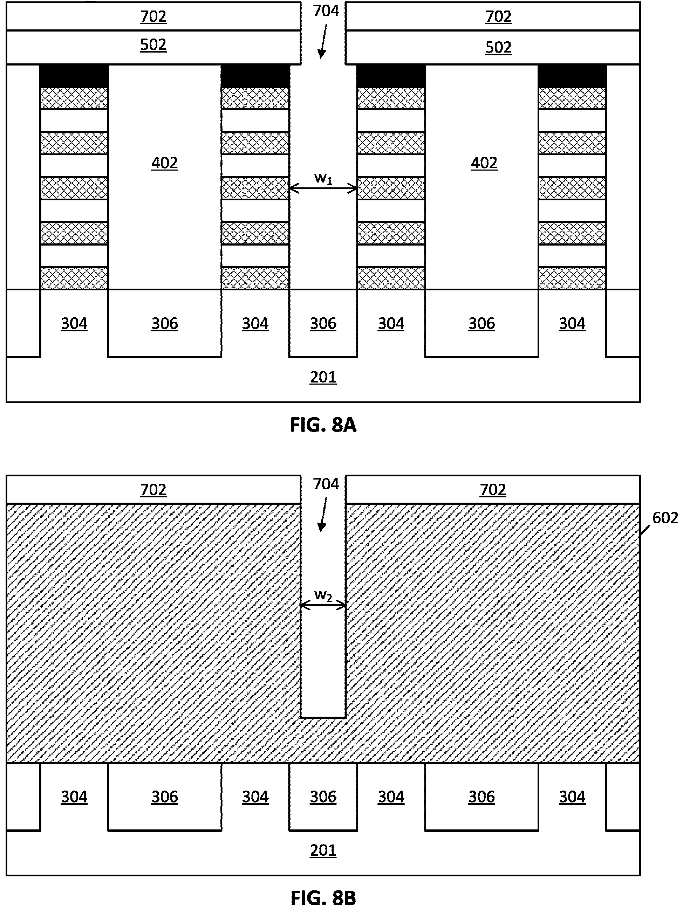

Figures 8A and 8B depict the cross-section views of the structure shown in Figures 7A and 7B, respectively, following the removal of portions 706 from within trench recess 704, according to some embodiments. Any suitable isotropic etching process may be used to remove portions 706 from within trench recess 704, thus exposing the sides of the fins. As noted above, the semiconductor material of the fins may have a thin protective dielectric layer (e.g., a layer of silicon dioxide) over them such that the semiconductor material of the fins is protected during the etching process to remove portions 706.

As a result of the removal of portions 706, trench recess 704 becomes wider along the gate trench as compared to the source/drain trench. For example, trench recess 704 may have a first width w₁ along the second direction within the gate trench (e.g., between the fins) and a second width w₂ along the second direction within the source/drain trench that is smaller than the first width w₁. In some examples, the second width w₂ is between about 2 nm and about 5 nm smaller than the first width w₁. In some examples, the second width w₂ is up to 10 nm smaller than the first width w₁. The first width w₁ may be between about 15 nm and about 25 nm. Due to natural tapering of trench recess 704 as it extends deeper towards substrate 201, the width comparison between different sections of trench recess 704 should be taken along the same plane.

Figures 9A and 9B depict the cross-section views of the structure shown in Figures 8A and 8B, respectively, following the formation of a dielectric spine within trench recess 704, according to some embodiments. The dielectric spine includes a sacrificial liner 902 and a dielectric core 904 on sacrificial liner 902. According to some embodiments, sacrificial liner 902 may be conformally deposited on all surfaces within trench recess 704 using any suitable technique, such as CVD, PECVD, or ALD. Sacrificial liner 902 may be very thin, such as less than 3 nm, less than 2 nm, or around 1 nm in thickness. According to some embodiments, sacrificial liner 902 includes a material that can be easily removed at a later time without damaging surrounding material structures. In some examples, sacrificial liner 902 includes silicon dioxide or aluminum oxide. Dielectric core 904 includes a material that is different from sacrificial liner 902 to impose sufficient etch selectivity between the materials. In some examples, dielectric core 904 includes silicon nitride, silicon oxynitride, or silicon carbonitride. The dielectric spine may be polished to both remove mask structure 702 and to planarize the top surface of the dielectric spine along with the top surface of dielectric fill 602 and the top surface of gate mask 502.

According to some embodiments, another etching process is used to punch through sacrificial liner 902 on the bottom surface of trench recess 704 prior to the formation of dielectric core 904. Figures 9A' and 9B' illustrate how dielectric core 904 may extend further below sacrificial liner 902. Following the formation of sacrificial liner 902, an anisotropic etching process (e.g., RIE) may be used to directionally punch through sacrificial liner 902 at the bottom of trench recess 704 and to etch an additional recess into at least a portion of dielectric fill 306 and/or dielectric fill 602. In some examples, dielectric core 904 is formed within the additional recess to extend below sacrificial liner 902 and into at least a portion of dielectric fill 306 and/or dielectric fill 602.

Figures 10A and 10B depict the cross-section views of the structure shown in Figures 9A and 9B, respectively, following the removal of dielectric fill 602 from within the source/drain trench, according to some embodiments. Another mask structure 1002 may first be patterned to protect the dielectric spine between the fins during the removal of dielectric fill 602. Mask structure 1002 may be any suitable dielectric or hard mask material. Any suitable etching process may be used to remove dielectric fill 602 from within the source/drain trench. Note that, in some examples, the removal of dielectric fill 602 also removes portions of sacrificial liner 902, thus exposing dielectric core 904 within the source/drain trench. According to an embodiment, a dielectric plug 1004 may remain beneath dielectric core 904 within the source/drain trench as seen in Figure 10B. Dielectric plug 1004 may include any portions of dielectric fill 602 and/or sacrificial liner 902 that were not fully removed during the etching process. In some embodiments, all of dielectric fill 602 is removed, such that dielectric plug 1004 is not present.

Figures 11A and 11B depict the cross-section views of the structure shown in Figures 10A and 10B, respectively, following the formation of source or drain regions 1102 at the ends of each of the fins (extending into and out of the page in Figure 11A), according to some embodiments. Source or drain regions 1102 may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, source or drain regions 1102 grown from different semiconductor devices may be aligned along the second direction in the source/drain trench as shown in Figure 11B. According to some embodiments, one or more bottom dielectric layers may be deposited prior to the formation of source or drain regions 1102 to provide isolation between source or drain regions 1102 and subfin regions 304.

According to some embodiments, another dielectric fill 1104 is provided within the source/drain trench. Dielectric fill 1104 may extend between adjacent ones of the source or drain regions 1102 along the second direction and also may extend up and over each of the source or drain regions 1102, according to some embodiments. Accordingly, each source or drain region may be isolated from any adjacent source or drain regions by dielectric fill 1104. Dielectric fill 1104 may be any suitable dielectric material, although in some embodiments, dielectric fill 1104 includes the same dielectric material as dielectric fill 306. According to some embodiments, a top surface of dielectric fill 1104 may be polished using, for example, chemical mechanical polishing (CMP). The top surface of dielectric fill 1104 may be polished until it is substantially coplanar with a top surface of mask structure 1002 or the top surface of gate mask 502 (after removing mask structure 1002).

Figures 12A and 12B depict the cross-section views of the structure shown in Figures 11A and 11B, respectively, following the removal of gate mask 502 and subsequent removal of sacrificial material 402 from the gate trench, according to some embodiments. A polishing procedure (e.g., CMP) may be used to remove gate mask 502 along with any portion of the dielectric spine that extending through gate mask 502. According to some embodiments, sacrificial material 402 may be removed using any suitable isotropic etching process leaving behind the fins extending across the gate trench. Note that the etching processes used to remove gate mask 502 and/or sacrificial material 402 may cause a top portion of the dielectric spine to be removed as well. The top surface of the dielectric spine may recess to any point that is still above the bottom surface of cap layer 302.

Figures 13A and 13B depict the cross-section views of the structure shown in Figures 12A and 12B, respectively, following the formation of nanosheets 1302 and nanoribbons 1304 from semiconductor layers 204, according to some embodiments. Depending on the dimensions of the structures, nanoribbons 1304 may also be considered nanowires. Sacrificial layers 202 may be removed from each of the fins in the gate trench using a selective isotropic etching process that removes the material of sacrificial layers 202 but does not remove (or removes very little of) semiconductor layers 204 or any other exposed layers within the gate trench. At this point, the suspended (sometimes called released) semiconductor layers 204 form nanosheets 1302 and nanoribbons 1304 that extend in the first direction (into and out of the page) between corresponding source or drain regions 1102. In some embodiments, nanosheets 1302 directly abut against sides of sacrificial liner 902.

Figures 14A and 14B depict the cross-section views of the structure shown in Figures 13A and 13B, respectively, following the removal of sacrificial liner 902 (or at least a majority of sacrificial liner 902), according to some embodiments. Any suitable isotropic etching process may be used to remove sacrificial liner 902 while leaving behind dielectric core 904. The removal of sacrificial liner 902 also leaves behind a space between nanosheets 1302 and dielectric core 904 along the second direction. In some examples, a portion of sacrificial liner 902 may remain directly beneath dielectric core 904 in the gate trench. In other examples, dielectric core 904 extends into dielectric fill 306 within the gate trench (as illustrated in Figure 9A').

Figures 15A and 15B depict the cross-section views of the structure shown in Figures 14A and 14B, respectively, following the formation of a gate dielectric 1502 around each of nanosheets 1302 and nanoribbons 1304. Gate dielectric 1502 may be conformally formed around nanosheets 1302 and nanoribbons 1304 using any suitable deposition process, such as thermal oxidation or atomic layer deposition (ALD). Gate dielectric 1502 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 1502 includes hafnium oxide with a thickness between about 1 nm and about 5 nm. In some embodiments, gate dielectric 1502 may include one or more silicates (e.g., titanium silicate, tungsten silicate, niobium silicate, and silicates of other transition metals). Gate dielectric 1502 may be a multilayer structure, in some examples. For instance, gate dielectric 1502 may include a first layer on nanosheets 1302 and nanoribbons 1304, and a second layer on the first layer. The first layer can be, for instance, an oxide of the semiconductor material (e.g., silicon dioxide) and the second layer can be a high-k dielectric material (e.g., hafnium oxide). In some embodiments, an annealing process may be carried out on gate dielectric 1502 to improve its quality when a high-k dielectric material is used.

According to some embodiments, at least a portion of gate dielectric 1502 forms around all sides of nanosheets 1302, including in the region between nanosheets 1302 and dielectric core 904 along the second direction. Gate dielectric 1502 may form in the region that had previously been occupied by sacrificial liner 902 between nanosheets 1302 and dielectric core 904. According to some embodiments, portions of gate dielectric 1502 may form on the sidewalls of dielectric core 904. For example, one or more high-k layers deposited as part of gate dielectric 1502 may also conformally deposit along any exposed surfaces of dielectric core 904 within the gate trench. The one or more high-k layers may or may not be part of the portion of gate dielectric 1502 between nanosheets 1302 and dielectric core 904 depending on the thickness of a thermally grown portion of gate dielectric 1502 directly on the surfaces of nanosheets 1302, according to some embodiments.

Figures 16A and 16B depict the cross-section views of the structure shown in Figures 15A and 15B, respectively, following the formation of gate electrodes 1602 within the gate trench and on gate dielectric 1502, according to some embodiments. Gate electrodes 1602 may extend along the second direction within the gate trench and may substantially fill any remaining volume within the gate trench. Gate electrodes 1602 can represent any number of conductive layers. The conductive gate electrodes 1602 may be deposited using electroplating, electroless plating, CVD, PECVD, ALD, or PVD, to name a few examples. In some embodiments, gate electrodes 1602 include doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrodes 1602 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrodes 1602) is planar with the top surface of other semiconductor elements, such as the spacer structures that define the gate trench. In some embodiments, a top surface of gate electrodes 1602 is substantially coplanar with a top surface of cap layer 302. In some examples, masking can be used to facilitate processing of one gate structure type, while the locations of other gate structure types are masked off, and vice-versa.

In some embodiments, no portions of gate electrodes 1602 are present between nanosheets 1302 and dielectric core 904 along the second direction (e.g., gate dielectric 1502 takes up the entire region between nanosheets 1302 and dielectric core 904 along the second direction. However, in some embodiments, thin portions 1604 of gate electrodes 1602 are present between nanosheets 1302 and dielectric core 904 as seen in the pulled-out view. In such examples, the devices directly on either side of dielectric core 904 act more like GAA devices than forksheet devices with a gate structure around all sides of the semiconductor channels. It should be understood that dielectric core 904 may also be more simply referred to as the dielectric spine of the forksheet arrangement that includes nanosheets 1302.

Figures 17A and 17B depict the cross-section views of the structure shown in Figures 16A and 16B, respectively, following the formation of gate cuts 1702 through other portions of the gate structure and additional polishing of the structure, according to some embodiments. Gate cuts 1702 may be formed by first etching a deep trench recess through the gate structure using any suitable metal gate etch process that iteratively etches through portions of gate electrodes 1602 while simultaneously protecting the sidewalls of the recess from lateral etching to provide a high height-to-width aspect ratio recess (e.g., aspect ratio of 5:1 or higher, or 10:1 or higher). The deep recesses may extend at least an entire height of the gate structures and into a portion of dielectric fill 306 or into a portion of substrate 201. According to some embodiments, the deep recesses are filled with one or more dielectric materials to form gate cuts 1702. In some examples, gate cuts 1702 include a high-k dielectric liner (e.g., silicon nitride) and a low-k dielectric fill (e.g., silicon dioxide). In some examples, gate cuts 1702 include a single material fill of silicon nitride, silicon oxynitride, or silicon oxycarbide. Other suitable dielectric materials may be used as well.

According to some embodiments, the top surface of the structure may be polished down to remove any residual materials present at the top of the structure. Each of gate cuts 1702 and dielectric core 904 electrically isolates the gate structures on either side of the corresponding gate cuts 1702 and dielectric core 904.

Figure 18 illustrates an example embodiment of a chip package 1800, in accordance with an embodiment of the present disclosure. As can be seen, chip package 1800 includes one or more dies 1802. One or more dies 1802 may include at least one integrated circuit having semiconductor devices, such as any of the semiconductor devices disclosed herein. One or more dies 1802 may include any other circuitry used to interface with other devices formed on the dies, or other devices connected to chip package 1800, in some example configurations.

As can be further seen, chip package 1800 includes a housing 1804 that is bonded to a package substrate 1806. The housing 1804 may be any standard or proprietary housing, and may provide, for example, electromagnetic shielding and environmental protection for the components of chip package 1800. The one or more dies 1802 may be conductively coupled to a package substrate 1806 using connections 1808, which may be implemented with any number of standard or proprietary connection mechanisms, such as solder bumps, ball grid array (BGA), pins, or wire bonds, to name a few examples. Package substrate 1806 may be any standard or proprietary package substrate, but in some cases includes a dielectric material having conductive pathways (e.g., including conductive vias and lines) extending through the dielectric material between the faces of package substrate 1806, or between different locations on each face. In some embodiments, package substrate 1806 may have a thickness less than 1 millimeter (e.g., between 0.1 millimeters and 0.5 millimeters), although any number of package geometries can be used. Additional conductive contacts 1812 may be disposed at an opposite face of package substrate 1806 for conductively contacting, for instance, a printed circuit board (PCB). One or more vias 1810 extend through a thickness of package substrate 1806 to provide conductive pathways between one or more of connections 1808 to one or more of contacts 1812. Vias 1810 are illustrated as single straight columns through package substrate 1806 for ease of illustration, although other configurations can be used (e.g., damascene, dual damascene, through-silicon via, or an interconnect structure that meanders through the thickness of substrate 1806 to contact one or more intermediate locations therein). In still other embodiments, vias 1810 are fabricated by multiple smaller stacked vias, or are staggered at different locations across package substrate 1806. In the illustrated embodiment, contacts 1812 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1812, to inhibit shorting.

In some embodiments, a mold material 1814 may be disposed around the one or more dies 1802 included within housing 1804 (e.g., between dies 1802 and package substrate 1806 as an underfill material, as well as between dies 1802 and housing 1804 as an overfill material). Although the dimensions and qualities of the mold material 1814 can vary from one embodiment to the next, in some embodiments, a thickness of mold material 1814 is less than 1 millimeter. Example materials that may be used for mold material 1814 include epoxy mold materials, as suitable. In some cases, the mold material 1814 is thermally conductive, in addition to being electrically insulating.

### Methodology

Figure 19 is a flow chart of a method 1900 for forming at least a portion of an integrated circuit, according to an embodiment. Various operations of method 1900 may be illustrated in Figures 2A - 17A and 2B - 17B. However, the correlation of the various operations of method 1900 to the specific components illustrated in the aforementioned figures is not intended to imply any structural and/or use limitations. Rather, the aforementioned figures provide one example embodiment of method 1900. Other operations may be performed before, during, or after any of the operations of method 1900. For example, method 1900 does not explicitly describe all processes that are performed to form common transistor structures. Some of the operations of method 1900 may be performed in a different order than the illustrated order.

Method 1900 begins with operation 1902 where at least two adjacent, parallel semiconductor fins are formed, according to some embodiments. The fins may extend lengthwise parallel to each other along a first direction. According to some embodiments, the fins include alternating layers of material (e.g., alternating layers of silicon and SiGe) that facilitates forming of nanoribbons and nanosheets during a gate forming process where one type of the alternating layers are selectively etched away so as to liberate the other type of alternating layers within the channel region, so that gate-all-around (GAA) and forksheet processes can be carried out. The alternating layers can be blanket deposited and then etched into fins, or deposited into fin-shaped trenches. According to some embodiments, the fins also include a cap layer over each fin that may be used as a hard mask to define the locations of the fins during, for example, an RIE process. The cap layer may be a dielectric material, such as silicon nitride. In some embodiments, this cap layer remains over the fins up through at least the formation of the gate structures.

According to some embodiments, a dielectric layer is formed around subfin portions of the fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 1900 continues with operation 1904 where a sacrificial material is formed between the fins. The sacrificial material may be formed from any suitable material that can be selectively removed at a later time without damaging the semiconductor material of the fins. In one example, the sacrificial material includes polysilicon. The sacrificial material may be polished back (using CMP, for example) until its top surface is substantially coplanar with a top surface of the cap layer over the fins.

Method 1900 continues with operation 1906 where a mask structure is formed over portions of the sacrificial material and fins. According to some embodiments, the mask structure may be patterned into strips that run orthogonally over the fins (e.g., along a second direction orthogonal to the first direction). The mask structure may include any suitable dielectric or hard mask material.

Method 1900 continues with operation 1908 where portions of the sacrificial material and fins not protected by the mask structure are removed. According to some embodiments, the exposed portions of the sacrificial material are removed using any suitable etching process. The sacrificial material remains between the fins beneath the mask structure.

According to some embodiments, following the patterning of the sacrificial material, spacer structures may be deposited over the structure and then etched back such that the spacer structures remain mostly only on sidewalls of any exposed structures, such as on the sidewalls of the sacrificial material. According to some embodiments, the spacer structures may be any suitable dielectric material, such as silicon nitride or silicon oxynitride.

After the spacer structures have been formed, exposed portions of the fins that were not protected by the mask structure are also removed to form a source/drain trench that runs along the second direction through the region where the fins are removed. The exposed portions of the fins may be removed using any suitable etching process, such as RIE. The protected region beneath the gate mask defines the gate trench that will eventually include the semiconductor channels and gate structures.

Method 1900 continues with operation 1910 where the source/drain trench is filled with a dielectric fill. According to some embodiments, the dielectric fill occupies the entire volume of the source/drain trench with a top surface that is polished to be substantially coplanar with a top surface of the mask structure (or the top surface of the spacer structures on the sidewalls of the sacrificial material). The dielectric fill may be any suitable dielectric material, such as silicon dioxide. In some examples, the dielectric fill is a different dielectric material compared to the spacer structures (e.g., with a high degree of etch selectivity).

Method 1900 continues with operation 1912 where the mask structure is removed, and a trench recess is formed through the sacrificial material between the fins and through a portion of the dielectric fill in the source/drain region. The trench recess may be etched using any suitable anisotropic etching process and may extend lengthwise along the first direction between the adjacent fins. Accordingly, the trench recess crosses through both the sacrificial material within the gate trench and the dielectric fill within the source/drain trench.

According to some embodiments, the depth of the trench recess changes as it crosses between the gate trench and the source/drain trench due to the different materials present in each. For example, the etch rate through the sacrificial material in the gate trench may be faster than the etch rate through the dielectric fill in the source/drain trench. Accordingly, the trench recess may be deeper within the gate trench as compared to the source/drain trench. In some embodiments, the width of the trench recess across the second direction is smaller than the distance between the adjacent fins along the second direction. As a result, portions of the sacrificial material may main along one or more sidewalls of the trench recess within the gate trench.

Method 1900 continues with operation 1914 where the portions of the sacrificial material on the sidewalls of the trench recess are removed. Any suitable isotropic etching process may be used to remove the sidewall portions of the sacrificial material from within the trench recess, thus exposing the sides of the fins. The semiconductor material of the fins may have a thin protective dielectric layer (e.g., a layer of silicon dioxide) over them such that the semiconductor material of the fins is protected during the etching process to remove the sidewall portions of the sacrificial material. As a result of the removal of the sidewall portions of the sacrificial material, the trench recess becomes wider within the gate trench as compared to its width within the source/drain trench.

Method 1900 continues with operation 1916 where a dielectric spine is formed within the trench recess between the adjacent fins. In some embodiments, the dielectric spine includes a dielectric liner and a dielectric core on the dielectric liner. The dielectric liner may include a high-k dielectric material while the dielectric core includes a low-k dielectric material. In some examples, the dielectric spine includes a single dielectric material that fills the entirety of the trench recess. In some embodiments, the dielectric spine includes a sacrificial liner (e.g., silicon dioxide) and a dielectric core on the sacrificial liner. In such examples, the sacrificial liner may be removed by a later process and leave behind the dielectric core as the dielectric spine.

Figure 20 is a flow chart of a method 2000 for forming at least a portion of an integrated circuit, according to an embodiment. Various operations of method 2000 may be illustrated in Figures 2A - 17A and 2B - 1B. However, the correlation of the various operations of method 2000 to the specific components illustrated in the aforementioned figures is not intended to imply any structural and/or use limitations. Rather, the aforementioned figures provide one example embodiment of method 2000. Other operations may be performed before, during, or after any of the operations of method 2000. For example, method 2000 does not explicitly describe all processes that are performed to form common transistor structures. Some of the operations of method 2000 may be performed in a different order than the illustrated order.

Method 2000 begins with operation 2002 where at least two adjacent, parallel semiconductor fins are formed, according to some embodiments. Operation 2002 may be substantially similar to operation 1902 discussed above. Accordingly, the adjacent fins may each include semiconductor layers alternating with sacrificial layers.

Method 2000 continues with operation 2004 where a dielectric spine is formed between the adjacent semiconductor fins. According to some embodiments, the dielectric spine includes a sacrificial liner along the outer edge of the dielectric spine and a dielectric core on the sacrificial liner. According to some embodiments, the dielectric spine is self-aligned between the adjacent semiconductor fins and is formed using a substantially similar process to that described above in operations 1904-1916. According to some embodiments, the sacrificial liner is formed to be very thin, such as less than 3 nm, or between 1 nm and 2 nm.

Method 2000 continues with operation 2006 where the sacrificial layers are removed from the adjacent fins on either side of the dielectric spine. According to some embodiments, an isotropic etching process may be used to remove the material of the sacrificial layers while leaving behind the material of the semiconductor layers. As a result, the remaining semiconductor layers form nanosheets on either side of the dielectric spine. The nanosheets may directly abut against the sacrificial liner of the dielectric spine.

Method 2000 continues with operation 2008 where the sacrificial liner is removed thus leaving a space between the nanosheets and the dielectric core along the second direction. Any suitable isotropic etching process may be used to remove the sacrificial liner while leaving behind the dielectric core. In one examples, an atomic layer etch (ALE) process is performed that removes the material of the sacrificial liner (e.g., silicon dioxide) while etching little to none of the other exposed materials. In some examples, a portion of the sacrificial liner may remain directly beneath the dielectric core in the gate trench.

Method 2000 continues with operation 2010 where a gate dielectric is formed around the nanosheets, including in the space between the nanosheets and the dielectric core. According to some embodiments, the gate dielectric may be conformally formed around the nanosheets using any suitable deposition process, such as thermal oxidation or ALD. The gate dielectric may include any number of suitable dielectric layers (such as silicon dioxide, and/or a high-k dielectric material).

According to some embodiments, the gate dielectric forms in a region that had previously been occupied by the sacrificial liner between the nanosheets and the dielectric core. According to some embodiments, portions of the gate dielectric form on the sidewalls of the dielectric core. For example, a first portion of the gate dielectric may include a thermally grown oxide directly on the nanoribbons and a second portion of the gate dielectric may include one or more high-k layers conformally deposited on the thermally grown oxide. The one or more high-k layers may also be conformally deposited along any exposed surfaces of the dielectric core within the gate trench. The one or more high-k layers may or may not be part of the portion of the gate dielectric between the nanosheets and the dielectric core depending on the thickness of the thermally grown portion of the gate dielectric, according to some embodiments.

Method 2000 continues with operation 2012 where a gate electrode is formed on the gate dielectric. The gate electrode can include any number of conductive material layers, such as any metals, metal alloys, or polysilicon. The gate electrode may be deposited using electroplating, electroless plating, CVD, ALD, PECVD, or PVD, to name a few examples. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of the gate electrode) is planar with the top surface of other semiconductor elements, such as the spacer structures that define the gate trench.

In some embodiments, no portions of the gate electrode are present between the nanosheets and the dielectric core along the second direction. However, in some embodiments, thin portions of the gate electrode are present between the nanosheets and the dielectric core in situations where the gate dielectric is not thick enough to close the gap between the nanosheets and the dielectric core along the second direction.

### Example System

FIG. 21 is an example computing system implemented with one or more of the integrated circuit structures as disclosed herein, in accordance with some embodiments of the present disclosure. As can be seen, the computing system 2100 houses a motherboard 2102. The motherboard 2102 may include a number of components, including, but not limited to, a processor 2104 and at least one communication chip 2106, each of which can be physically and electrically coupled to the motherboard 2102, or otherwise integrated therein. As will be appreciated, the motherboard 2102 may be, for example, any printed circuit board (PCB), whether a main board, a daughterboard mounted on a main board, or the only board of system 2100, etc.

Depending on its applications, computing system 2100 may include one or more other components that may or may not be physically and electrically coupled to the motherboard 2102. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 2100 may include one or more integrated circuit structures or devices configured in accordance with an example embodiment, such as a module including an integrated circuit on a substrate, the substrate having forksheet transistor structures as variously described herein. In some embodiments, multiple functions can be integrated into one or more chips (e.g., for instance, note that the communication chip 2106 can be part of or otherwise integrated into the processor 2104).

The communication chip 2106 enables wireless communications for the transfer of data to and from the computing system 2100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 2106 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 2100 may include a plurality of communication chips 2106. For instance, a first communication chip 2106 may be dedicated to shorter range wireless communications such as Wi-Fi and Bluetooth and a second communication chip 2106 may be dedicated to longer range wireless communications such as GPS, EDGE, GPRS, CDMA, WiMAX, LTE, Ev-DO, and others.

The processor 2104 of the computing system 2100 includes an integrated circuit die packaged within the processor 2104. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 2106 also may include an integrated circuit die packaged within the communication chip 2106. In accordance with some such example embodiments, the integrated circuit die of the communication chip includes one or more semiconductor devices as variously described herein. As will be appreciated in light of this disclosure, note that multi-standard wireless capability may be integrated directly into the processor 2104 (e.g., where functionality of any chips 2106 is integrated into processor 2104, rather than having separate communication chips). Further note that processor 2104 may be a chip set having such wireless capability. In short, any number of processor 2104 and/or communication chips 2106 can be used. Likewise, any one chip or chip set can have multiple functions integrated therein.

In various implementations, the computing system 2100 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 2100 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device and a second semiconductor device. The first semiconductor device has a first semiconductor material extending in a first direction from a first source or drain region, and a first gate structure extending in a second direction over the first semiconductor material. The second semiconductor device has a second semiconductor material extending in the first direction from a second source or drain region, and a second gate structure extending in the second direction over the second semiconductor material. The second source or drain region is aligned with the first source or drain region along the second direction The integrated circuit further includes a dielectric spine extending in the first direction between the first semiconductor material and the second semiconductor material and between the first source or drain region and the second source or drain region. The dielectric spine has a first width along the second direction between the first semiconductor material and the second semiconductor material and a second width between the first source or drain region and the second source or drain region that is at least 2 nm smaller than the first width.

Example 2 includes the integrated circuit of Example 1, wherein the first semiconductor material comprises first one or more semiconductor nanosheets and the second semiconductor material comprises second one or more semiconductor nanosheets.

Example 3 includes the integrated circuit of Example 2, wherein the first one or more semiconductor nanosheets and the second one or more semiconductor nanosheets comprise germanium, silicon, or both.

Example 4 includes the integrated circuit of any one of Examples 1-3, wherein the dielectric spine comprises silicon, oxygen, and nitrogen.

Example 5 includes the integrated circuit of any one of Examples 1-4, wherein the first gate structure comprises a first gate dielectric around the first semiconductor material and the second gate structure comprises a second gate dielectric around the second semiconductor material.

Example 6 includes the integrated circuit of Example 5, wherein the first gate dielectric is directly between the first semiconductor material and the dielectric spine along the second direction, and the second gate dielectric is directly between the second semiconductor material and the dielectric spine along the second direction.

Example 7 includes the integrated circuit of Example 6, wherein the first gate dielectric and the second gate dielectric each comprise a high-k dielectric material.

Example 8 includes the integrated circuit of Example 5, wherein the first gate structure comprises a first gate electrode, and the second gate structure comprises a second gate electrode, at least a portion of the first gate electrode being between the first gate dielectric and the dielectric spine along the second direction and at least a portion of the second gate electrode being between the second gate dielectric and the dielectric spine along the second direction.

Example 9 includes the integrated circuit of Example 8, wherein the at least a portion of the first gate electrode has a width along the second direction of less than 2 nm, and the at least a portion of the second gate electrode has a width along the second direction of less than 2 nm.

Example 10 includes the integrated circuit of any one of Examples 1-9, wherein a distance between the dielectric spine and the first semiconductor material along the second direction is substantially the same as a distance between the dielectric spine and the second semiconductor material along the second direction.

Example 11 includes the integrated circuit of any one of Examples 1-10, wherein the dielectric spine has a first height along a third direction between the first semiconductor material and the second semiconductor material and a second height along the third direction between the first source or drain region and the second source or drain region that is at least 10 nm smaller than the first height.

Example 12 is a die that includes the integrated circuit of any one of Examples 1-11.

Example 13 is an electronic device that includes a chip package having one or more dies. At least one of the one or more dies includes a first semiconductor material extending in a first direction from a first source or drain region, a first gate structure extending in a second direction over the first semiconductor material, a second semiconductor material extending in the first direction from a second source or drain region, a second gate structure extending in the second direction over the second semiconductor material, and a dielectric spine extending in the first direction between the first semiconductor material and the second semiconductor material and between the first source or drain region and the second source or drain region. The second source or drain region is aligned with the first source or drain region along the second direction. The dielectric spine has a first width along the second direction between the first semiconductor material and the second semiconductor material and a second width between the first source or drain region and the second source or drain region that is at least 2 nm smaller than the first width.

Example 14 includes the electronic device of Example 13, wherein the first semiconductor material comprises first one or more semiconductor nanosheets and the second semiconductor material comprises second one or more semiconductor nanosheets.

Example 15 includes the electronic device of Example 14, wherein the first one or more semiconductor nanosheets and the second one or more semiconductor nanosheets comprise germanium, silicon, or both.

Example 16 includes the electronic device of any one of Examples 13-15, wherein the dielectric spine comprises silicon, oxygen, and nitrogen.

Example 17 includes the electronic device of any one of Examples 13-16, wherein the first gate structure comprises a first gate dielectric around the first semiconductor material and the second gate structure comprises a second gate dielectric around the second semiconductor material.

Example 18 includes the electronic device of Example 17, wherein the first gate dielectric is directly between the first semiconductor material and the dielectric spine along the second direction, and the second gate dielectric is directly between the second semiconductor material and the dielectric spine along the second direction.

Example 19 includes the electronic device of Example 18, wherein the first gate dielectric and the second gate dielectric each comprise a high-k dielectric material.

Example 20 includes the electronic device of Example 17, wherein the first gate structure comprises a first gate electrode, and the second gate structure comprises a second gate electrode, at least a portion of the first gate electrode being between the first gate dielectric and the dielectric spine along the second direction and at least a portion of the second gate electrode being between the second gate dielectric and the dielectric spine along the second direction.

Example 21 includes the electronic device of Example 20, wherein the at least a portion of the first gate electrode has a width along the second direction of less than 2 nm, and the at least a portion of the second gate electrode has a width along the second direction of less than 2 nm.

Example 22 includes the electronic device of any one of Examples 13-21, wherein a distance between the dielectric spine and the first semiconductor material along the second direction is substantially the same as a distance between the dielectric spine and the second semiconductor material along the second direction.

Example 23 includes the electronic device of any one of Examples 13-22, wherein the dielectric spine has a first height along a third direction between the first semiconductor material and the second semiconductor material and a second height along the third direction between the first source or drain region and the second source or drain region that is at least 10 nm smaller than the first height.

Example 24 includes the electronic device of any one of Examples 13-23, further comprising a printed circuit board, wherein the chip package is attached to the printed circuit board.

Example 25 is a method of forming an integrated circuit. The method includes forming a first fin comprising first semiconductor material and a first dielectric cap over the first semiconductor material, and a second fin comprising second semiconductor material and a second dielectric cap over the second semiconductor material, wherein the first fin and the second fin are adjacent and extend parallel to one another along a first direction; forming a sacrificial material between the first fin and the second fin and extending along at least an entire height of the first fin and the second fin; forming a mask structure over portions of the sacrificial material and over portions of the first and second fins; removing portions of the sacrificial material and the first and second fins not protected by the mask structure to form a source/drain trench; forming a dielectric fill within the source/drain trench; etching a trench extending in the first direction through at least an entire height of the sacrificial material between the first fin and the second fin and through at least a portion of the dielectric fill to form a trench recess; removing the sacrificial material on sidewalls of the trench recess; and forming one or more dielectric materials within the trench recess to form a dielectric spine between the first fin and the second fin.

Example 26 includes the method of Example 25, wherein forming the sacrificial material comprises depositing amorphous silicon or polysilicon between the first fin and the second fin.

Example 27 includes the method of Example 25 or 26, further comprising polishing a top surface of the sacrificial material to be substantially coplanar with a top surface of the first dielectric cap or the second dielectric cap.

Example 28 includes the method of any one of Examples 25-27, wherein forming the one or more dielectric materials includes forming a dielectric liner within the trench recess, and forming a dielectric fill on the dielectric liner.

Example 29 includes the method of Example 28, further including releasing the first and second semiconductor material to form first and second semiconductor nanosheets, respectively, on either side of the dielectric spine; removing the dielectric liner of the dielectric spine; and forming a first gate dielectric around the first semiconductor nanosheets and a second gate dielectric around the second semiconductor nanosheets, such that the first gate dielectric is between the first semiconductor nanosheets and the dielectric fill of the dielectric spine along a second direction substantially orthogonal to the first direction, and the second gate dielectric is between the second semiconductor nanosheets and the dielectric fill of the dielectric spine along the second direction.

Example 30 is a method of forming an integrated circuit. The method includes forming a first fin comprising first semiconductor material layers and first sacrificial material layers, and a second fin comprising second semiconductor material layers and second sacrificial material layers, wherein the first fin and the second fin are adjacent and extend parallel to one another along a first direction; forming a dielectric spine directly between and contacting the first fin and the second fin, the dielectric spine comprising a dielectric liner and a dielectric fill on the dielectric liner; removing the first sacrificial layers and the second sacrificial layers to leave first and second nanosheets, respectively, on either side of the dielectric spine; removing the dielectric liner of the dielectric spine; and forming a first gate dielectric around the first semiconductor nanosheets and a second gate dielectric around the second semiconductor nanosheets, such that the first gate dielectric is between the first semiconductor nanosheets and the dielectric fill of the dielectric spine along a second direction substantially orthogonal to the first direction, and the second gate dielectric is between the second semiconductor nanosheets and the dielectric fill of the dielectric spine along the second direction.

Example 31 includes the method of Example 30, wherein the first and second gate dielectrics each comprises a high-k dielectric layer between the first and second gate dielectrics and the dielectric fill of the dielectric spine.

Example 32 includes the method of Example 30 or 31, wherein the dielectric liner comprises silicon and oxygen, and the dielectric fill comprises silicon and nitrogen.

Example 33 includes the method of any one of Examples 30-32, wherein the first gate dielectric directly contacts the dielectric fill of the dielectric spine along the second direction between the first nanosheets and the dielectric fill of the dielectric spine, and the second gate dielectric directly contacts the dielectric fill of the dielectric spine along the second direction between the second nanosheets and the dielectric fill of the dielectric spine.

Example 34 includes the method of any one of Examples 30-32, further comprising forming a first gate electrode on the first gate dielectric and a second gate electrode on the second gate dielectric, wherein a portion of the first gate electrode is between the first nanosheets and the dielectric fill of the dielectric spine along the second direction, and a portion of the second gate electrode is between the second nanosheets and the dielectric fill of the dielectric spine along the second direction.

Example 35 is an integrated circuit that includes a first semiconductor device having a first semiconductor material extending in a first direction from a first source or drain region and a first gate structure extending in a second direction over the first semiconductor material, a second semiconductor device having a second semiconductor material extending in the first direction from a second source or drain region and a second gate structure extending in the second direction over the second semiconductor material, and a dielectric spine extending in the first direction between the first semiconductor material and the second semiconductor material and between the first source or drain region and the second source or drain region. The second source or drain region is aligned with the first source or drain region along the second direction. The dielectric spine has a first height along a third direction between the first semiconductor material and the second semiconductor material and a second height along the third direction between the first source or drain region and the second source or drain region that is at least 10 nm smaller than the first height.

Example 36 includes the integrated circuit of example 35, wherein the first semiconductor material comprises first one or more semiconductor nanosheets and the second semiconductor material comprises second one or more semiconductor nanosheets.

Example 37 includes the integrated circuit of example 36, wherein the first one or more semiconductor nanosheets and the second one or more semiconductor nanosheets comprise germanium, silicon, or both.

Example 38 includes the integrated circuit of any one of Examples 35-37, wherein the dielectric spine comprises silicon, oxygen, and nitrogen.

Example 39 includes the integrated circuit of any one of Examples 35-38, wherein the first gate structure comprises a first gate dielectric around the first semiconductor material and the second gate structure comprises a second gate dielectric around the second semiconductor material.

Example 40 includes the integrated circuit of example 39, wherein the first gate dielectric is directly between the first semiconductor material and the dielectric spine along the second direction, and the second gate dielectric is directly between the second semiconductor material and the dielectric spine along the second direction.

Example 41 includes the integrated circuit of Example 39 or 40, wherein the first gate dielectric and the second gate dielectric each comprise a high-k dielectric material.

Example 42 includes the integrated circuit of example 39, wherein the first gate structure comprises a first gate electrode, and the second gate structure comprises a second gate electrode, at least a portion of the first gate electrode being between the first gate dielectric and the dielectric spine along the second direction and at least a portion of the second gate electrode being between the second gate dielectric and the dielectric spine along the second direction.

Example 43 includes the integrated circuit of example 42, wherein the at least a portion of the first gate electrode has a width along the second direction of less than 2 nm, and the at least a portion of the second gate electrode has a width along the second direction of less than 2 nm.

Example 44 includes the integrated circuit of any one of Examples 35-43, wherein a distance between the dielectric spine and the first semiconductor material along the second direction is substantially the same as a distance between the dielectric spine and the second semiconductor material along the second direction.

Example 45 includes the integrated circuit of any one of Examples 35-44, wherein the dielectric spine has a first width along the second direction between the first semiconductor material and the second semiconductor material and a second width between the first source or drain region and the second source or drain region that is at least 2 nm smaller than the first width.

Example 46 is a die that includes the integrated circuit of any one of Examples 35-45.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor material extending in a first direction from a first source or drain region, and a first gate structure extending in a second direction over the first semiconductor material;
a second semiconductor device having a second semiconductor material extending in the first direction from a second source or drain region, and a second gate structure extending in the second direction over the second semiconductor material, and wherein the second source or drain region is aligned with the first source or drain region along the second direction; and
a dielectric spine extending in the first direction between the first semiconductor material and the second semiconductor material and between the first source or drain region and the second source or drain region, wherein the dielectric spine has a first width along the second direction between the first semiconductor material and the second semiconductor material and a second width between the first source or drain region and the second source or drain region that is at least 2 nm smaller than the first width.

2. The integrated circuit of claim 1, wherein the first semiconductor material comprises first one or more semiconductor nanosheets and the second semiconductor material comprises second one or more semiconductor nanosheets.

3. The integrated circuit of claim 2, wherein the first one or more semiconductor nanosheets and the second one or more semiconductor nanosheets comprise germanium, silicon, or both.

4. The integrated circuit of any one of claims 1 through 3, wherein the dielectric spine comprises silicon, oxygen, and nitrogen.

5. The integrated circuit of any one of claims 1 through 4, wherein the first gate structure comprises a first gate dielectric around the first semiconductor material and the second gate structure comprises a second gate dielectric around the second semiconductor material.

6. The integrated circuit of claim 5, wherein the first gate dielectric is directly between the first semiconductor material and the dielectric spine along the second direction, and the second gate dielectric is directly between the second semiconductor material and the dielectric spine along the second direction.

7. The integrated circuit of claim 6, wherein the first gate dielectric and the second gate dielectric each comprise a high-k dielectric material.

8. The integrated circuit of claim 5, 6 or 7, wherein the first gate structure comprises a first gate electrode, and the second gate structure comprises a second gate electrode, at least a portion of the first gate electrode being between the first gate dielectric and the dielectric spine along the second direction and at least a portion of the second gate electrode being between the second gate dielectric and the dielectric spine along the second direction.

9. The integrated circuit of claim 8, wherein the at least a portion of the first gate electrode has a width along the second direction of less than 2 nm, and the at least a portion of the second gate electrode has a width along the second direction of less than 2 nm.

10. The integrated circuit of any one of claims 1 through 9, wherein a distance between the dielectric spine and the first semiconductor material along the second direction is substantially the same as a distance between the dielectric spine and the second semiconductor material along the second direction.

11. The integrated circuit of any one of claims 1 through 10, wherein the dielectric spine has a first height along a third direction between the first semiconductor material and the second semiconductor material and a second height along the third direction between the first source or drain region and the second source or drain region that is at least 10 nm smaller than the first height.

12. A die comprising the integrated circuit of any one of claims 1 through 11.

13. A method of forming an integrated circuit, the method comprising:
forming a first fin comprising first semiconductor material layers and first sacrificial material layers, and a second fin comprising second semiconductor material layers and second sacrificial material layers, wherein the first fin and the second fin are adjacent and extend parallel to one another along a first direction;
forming a dielectric spine directly between and contacting the first fin and the second fin, the dielectric spine comprising a dielectric liner and a dielectric fill on the dielectric liner;
removing the first sacrificial layers and the second sacrificial layers to leave first and second nanosheets, respectively, on either side of the dielectric spine;
removing the dielectric liner of the dielectric spine; and
forming a first gate dielectric around the first semiconductor nanosheets and a second gate dielectric around the second semiconductor nanosheets, such that the first gate dielectric is between the first semiconductor nanosheets and the dielectric fill of the dielectric spine along a second direction substantially orthogonal to the first direction, and the second gate dielectric is between the second semiconductor nanosheets and the dielectric fill of the dielectric spine along the second direction.

14. The method of claim 13, wherein the first and second gate dielectrics each comprises a high-k dielectric layer between the first and second gate dielectrics and the dielectric fill of the dielectric spine.

15. The method of claim 13 or 14, further comprising forming a first gate electrode on the first gate dielectric and a second gate electrode on the second gate dielectric, wherein a portion of the first gate electrode is between the first nanosheets and the dielectric fill of the dielectric spine along the second direction, and a portion of the second gate electrode is between the second nanosheets and the dielectric fill of the dielectric spine along the second direction.
